# EUROPEAN PATENT APPLICATION

(11) **EP 1 672 720 A2**
(43) Date of publication of application: **21.06.2006**
(21) Application number: 05257711.1
(22) Date of filing: 15.12.2005
(51) Int. Cl.: H01L 51/52, H01L 51/54

(54) **Surface modified electrodes and devices using reduced organic materials**

(30) Priority: 20.12.2004 US 17473; 19.04.2005 US 110276
(71) Applicant: The General Electric Company, Schenectady NY 12345 (US)
(72) Inventor: Liu, Jie, Niskayuna New York 12309 (US); Duggal, Anil Raj, Niskayuna New York 12309 (US); Cella, James Anthony, Clifton Park New York 12065 (US); Faircloth, Tami Janene, Powell Wyoming 82435 (US); Lewis, Larry Neil, Scotia New York 12302 (US); Litz, Kyle Erik, Ballston Spa New York 12020 (US); Shiang, Joseph John, Niskayuna New York 12065 (US)
(74) Representative: Goode, Ian Roy

(57) **Abstract**

An electrooptic device (10) and a surface modified electrode comprising a reduced organic material are provided. The reduced organic materials lower the work function of an electrode surface; they are also electro-active. These capabilities facilitate their use in production of more efficient electrooptic devices. The electrooptic device has at least a first conductive layer (20), a second conductive layer (30), and an electro-active layer (40) of the reduced organic material disposed between the first and second conductive layers.. The surface modified electrode comprises at least one conductive layer and at least one reduced polymeric material. Methods for using the organic electro-active material for producing electrooptic devices, and operating the electrooptic devices are also disclosed. Coating compositions and coated articles comprising the reduced polymeric materials are also provided.

## Description

The present invention relates generally to surface modified electrodes and devices comprising a reduced organic material. Further, the invention relates to a coating composition suitable for producing the surface modified electrode; and electrooptic devices comprising such surface modified electrodes. Further still, the invention relates to electrooptic devices having one or more electro-active layers which are electroluminescent. More particularly, the invention relates to such electro-active layers having reduced organic materials.

Electrooptic devices may be employed in a variety of electronic products, such as computer displays, graphic displays, sign displays, signs or signage, lighting, photodetectors, and so on. Examples of electrooptic devices include electroluminescent devices and organic light emitting electrochemical cells. In general, the design and operation of electrooptic devices incorporate the principle of conversion between optical energy and electrical energy. Moreover, the design and operation of electrooptic devices depend, in part, on the transport of charges between an electrode and an adjacent medium within the electrooptic device. Unfortunately, inefficient transport of charges between the electrode (e.g., cathode) and the adjacent medium (e.g., an active layer that emits light) may result in problematic operation of the electrooptic device.

Electroluminescent ("EL") devices are electrooptic devices that may be classified as either organic or inorganic. Electroluminescent devices have been produced in different shapes for many applications and are well known in the fields graphic display and imaging art. In particular organic EL devices ("OELDs"), which have been developed recently, offer a reduced barrier for electron transport relative to inorganic EL devices, and, thus, offer the benefits of lower activation voltage and higher brightness. In addition, OELDs are generally simpler to manufacture than inorganic EL devices. As a result, OELDs offer the promise of more widespread applications. However, OELDs would benefit from an even lower barrier for electron or charge transport between its electrode(s) (e.g., cathode) and active layer(s).

An OELD is typically a thin film structure formed on a substrate such as glass or plastic. A light-emitting layer of an organic EL material and optional adjacent organic semiconductor layers are sandwiched between a cathode and an anode. The organic semiconductor layers include organic materials and may be either hole (positive charge)-injecting or electron (negative charge)-injecting layers. The material for the light-emitting layer of the OELD may be selected from many organic EL materials that emit light at different wavelengths. Moreover, the light-emitting organic layer may include multiple sublayers, each having a different organic EL material, for example. Commonly, state-of-the-art organic EL materials can emit electromagnetic ("EM") radiation having narrow ranges of wavelengths in the visible spectrum. It should be noted that unless specifically stated otherwise, the terms "EM radiation" and "light" are used interchangeably herein to mean generally radiation having wavelengths in the range from ultraviolet ("UV") to mid-infrared ("mid-IR") or, in other words, wavelengths in the range from about 300 nanometers to about 10 micrometers.

Typically, the electro-active materials as employed in most state-of-the-art devices include one or more un-doped or unmodified organic materials, that is, these organic materials are not chemically modified. Such unmodified organic materials, upon passage of an electric current are intrinsically light-emitting. Interfacial doping of intrinsically organic materials is known to improve charge injection from the electrode, and has been generally achieved by vapor deposition of reactive metals on the intrinsically EL organic materials. However, interfacial doping processes can lead to damage of the intrinsically EL organic materials, as well as adversely affect their photoluminescence behavior, thus resulting in impaired overall performance of the device.

Reducing or eliminating barriers for charge injection between the electro-active organic material layer and an electrode enhances the device efficiency. Metals having low work functions, such as the alkali and alkaline-earth metals, are often used in a cathode material to promote electron injection. However, these metals are susceptible to degradation upon exposure to the environment. Therefore, devices using these metals as cathode materials require rigorous encapsulation.. Other electrooptic or opto-electronic devices, such as photovoltaic cells and organic light-emitting electrochemical cells (LECs) can also benefit from a lower barrier for electron transport across the interface between an active layer and an adjacent cathode.

There is a need for electro-active materials and methods that can be used for producing electrooptic devices having better performance features, such as high device efficiency (e.g., luminosity output) at a relatively lower current density and shorter turn-on time, and the like. In particular, there is a need for materials that lower the charge injection barrier, thereby facilitating charge injection between the electro-active organic material layer and the electrode in an electrooptic device, and at the same time, substantially preserve the long - term stability of the device.

Briefly, in one aspect of the invention, an electrooptic device comprising a first conductive layer, a second conductive layer, and an electro-active layer disposed between the first and second conductive layers is provided. The electro-active layer comprises a first organic electro-active material, which comprises a reduced organic material.

In another aspect of the invention, an electrooptic device comprising a cathode, an anode, and an electro-active layer disposed between the cathode and the anode; wherein the electro-active layer comprises a reduced polyfluorene.

In still another aspect of the invention, a method for fabricating an electrooptic device is provided. The method comprises: disposing a layer of an electro-active material between a first conductive layer and a second conductive layer; wherein the electro-active material comprises a first electro-active organic material; which comprises a reduced organic material.

Yet another aspect of the invention is an electro-active material comprising at least one cationic species and a reduced organic material, said reduced organic material comprising at least one additional electron relative to a corresponding reducible neutral precursor.

Yet another aspect of the invention is a device comprising a display, where the display comprises a plurality of electrooptic devices. At least one of the electrooptic devices comprises a first organic electro-active material, said first organic electro-active material comprising a reduced organic material.

In another aspect, the present invention provides a surface modified electrode comprising at least one conductive layer; and at least one reduced organic material disposed upon a surface of said conductive layer, said reduced organic material comprising at least one additional electron relative to a corresponding neutral organic precursor and at least one cationic species.

In still another aspect, the invention provides a surface modified electrode comprising at least one conductive layer, and at least one reduced polymeric organic material, wherein the reduced polymeric organic material comprises at least one additional electron relative to a corresponding neutral polymeric organic precursor, and at least one cationic species.

Another aspect of the invention is a coating composition comprising at least one reduced polymeric organic material, where the reduced polymeric organic material comprises at least one additional electron relative to a corresponding neutral polymeric organic precursor, and at least one cationic species; and at least one polar aprotic solvent.

Yet another aspect of the invention is an electrooptic device comprising a surface modified first electrode; a second electrode; and an electroluminescent organic material disposed between the first electrode and the second electrode; wherein the surface modified first electrode comprises at least one conductive layer, and at least one reduced polymeric organic material, said reduced polymeric organic material comprising at least one additional electron relative to a corresponding neutral polymeric organic precursor and at least one cationic species.

These and other features, aspects, and advantages of the present invention will become better understood when the following detailed description is read with reference to the accompanying drawings in which like characters represent like parts throughout the drawings, wherein:
Figure 1 is a schematic representation of an electrooptic device having a first organic electro-active material layer disposed between a first and a second conductive layer, in accordance with an exemplary embodiment of the present invention;
Figure 2 is a schematic representation of an electrooptic device having adjacent layers of a first organic electro-active material layer and at least one of an electron transport layer, hole transport layer, or a charge confinement layer, disposed between a first and a second conductive layer, in accordance with an exemplary embodiment of the present invention;
Figure 3 is a schematic representation of an electrooptic device having adjacent layers of a first and a second organic electro-active material layer, disposed between a first and a second conductive layer, in accordance with an exemplary embodiment of the present invention;
Figure 4 is a graphical plot of current density versus efficiency for the electrooptic devices ITO/PEDOT/K-ADS131 BE/AI;
ITO/PEDOT/ADS131 BE/NaF-Al; and ITO/PEDOT/ADS131 BE/AI, in accordance with an exemplary embodiment of the present invention; and
Figure 5 is a graphical plot of current density versus efficiency for the electrooptic devices ITO/PEDOT/poly(TPD)/K-ADS131 BE/AI; ITO/PEDOT/poly(TPD)/ADS131 BE/NaF-AI; and ITO/PEDOT/ADS131 BE/NaF-Al, in accordance with an exemplary embodiment of the present invention.

In the following specification and the claims which follow, reference will be made to a number of terms which shall be defined to have the following meanings.

The singular forms "a", "an" and "the" include plural referents unless the context clearly dictates otherwise.

"Optional" or "optionally" means that the subsequently described event or circumstance may or may not occur, and that the description includes instances where the event occurs and instances where it does not.

Unless specifically stated otherwise, the terms "electromagnetic radiation," "EM radiation" and "light" are used interchangeably in this disclosure to mean generally radiation having wavelengths in the range from ultraviolet ("UV") to mid-infrared ("mid-IR") or, in other words, wavelengths in the range from about 300 nanometers to about 10 micrometers.

As used herein, the term "aliphatic radical" refers to an organic radical having a valence of at least one consisting of a linear or branched array of atoms which is not cyclic. Aliphatic radicals are defined to comprise at least one carbon atom. The array of atoms comprising the aliphatic radical may include heteroatoms such as nitrogen, sulfur, silicon, selenium and oxygen or may be composed exclusively of carbon and hydrogen. For convenience, the term "aliphatic radical" is defined herein to encompass, as part of the "linear or branched array of atoms which is not cyclic" a wide range of functional groups such as alkyl groups, alkenyl groups, alkynyl groups, halo alkyl groups, conjugated dienyl groups, alcohol groups, ether groups, aldehyde groups, ketone groups, carboxylic acid groups, acyl groups (for example carboxylic acid derivatives such as esters and amides), amine groups, nitro groups and the like. For example, the 4-methylpent-1-yl radical is a C₆ aliphatic radical comprising a methyl group, the methyl group being a functional group which is an alkyl group. Similarly, the 4-nitrobut-1-yl group is a C₄ aliphatic radical comprising a nitro group, the nitro group being a functional group. An aliphatic radical may be a haloalkyl group which comprises one or more halogen atoms which may be the same or different. Halogen atoms include, for example; fluorine, chlorine, bromine, and iodine. Aliphatic radicals comprising one or more halogen atoms include the alkyl halides trifluoromethyl, bromodifluoromethyl, chlorodifluoromethyl, hexafluoroisopropylidene, chloromethyl; difluorovinylidene; trichloromethyl, bromodichloromethyl, bromoethyl, 2-bromotrimethylene (e.g. -CH₂CHBrCH₂-), and the like. Further examples of aliphatic radicals include allyl, aminocarbonyl (i.e. -CONH₂), carbonyl, dicyanoisopropylidene (i.e. - CH₂C(CN)₂CH₂-), methyl (i.e. -CH₃), methylene (i.e. -CH₂-), ethyl, ethylene, formyl (i.e.-CHO), hexyl, hexamethylene, hydroxymethyl (i.e.-CH₂OH), mercaptomethyl (i.e. -CH₂SH), methylthio (i.e. -SCH₃), methylthiomethyl (i.e. -CH₂SCH₃), methoxy, methoxycarbonyl (i.e. CH₃OCO-), nitromethyl (i.e. - CH₂NO₂), thiocarbonyl, trimethylsilyl ( i.e.(CH₃)₃Si-), t-butyldimethylsilyl, trimethyoxysilypropyl (i.e. (CH₃O)₃SiCH₂CH₂CH₂-), vinyl, vinylidene, and the like. By way of further example, a C₁- C₁₀ aliphatic radical contains at least one but no more than 10 carbon atoms. A methyl group (i.e. CH₃-) is an example of a C₁ aliphatic radical. A decyl group (i.e. CH₃(CH2)₉-) is an example of a C₁₀ aliphatic radical.

As used herein, the term "aromatic radical" refers to an array of atoms having a valence of at least one comprising at least one aromatic group. The array of atoms having a valence of at least one comprising at least one aromatic group may include heteroatoms such as nitrogen, sulfur, selenium, silicon and oxygen, or may be composed exclusively of carbon and hydrogen. As used herein, the term "aromatic radical" includes but is not limited to phenyl, pyridyl, furanyl, thienyl, naphthyl, phenylene, and biphenyl radicals. As noted, the aromatic radical contains at least one aromatic group. The aromatic group is invariably a cyclic structure having 4n+2 "delocalized" electrons where "n" is an integer equal to 1 or greater, as illustrated by phenyl groups (n = 1), thienyl groups (n = 1), furanyl groups (n = 1), naphthyl groups (n = 2), azulenyl groups (n = 2), anthraceneyl groups (n = 3) and the like. The aromatic radical may also include nonaromatic components. For example, a benzyl group is an aromatic radical which comprises a phenyl ring (the aromatic group) and a methylene group (the nonaromatic component). Similarly a tetrahydronaphthyl radical is an aromatic radical comprising an aromatic group (C₆H₃) fused to a nonaromatic component -(CH₂)₄-. For convenience, the term "aromatic radical" is defined herein to encompass a wide range of functional groups such as alkyl groups, alkenyl groups, alkynyl groups, haloalkyl groups, haloaromatic groups, conjugated dienyl groups, alcohol groups, ether groups, aldehydes groups, ketone groups, carboxylic acid groups, acyl groups (for example carboxylic acid derivatives such as esters and amides), amine groups, nitro groups, and the like. For example, the 4-methylphenyl radical is a C₇ aromatic radical comprising a methyl group, the methyl group being a functional group which is an alkyl group. Similarly, the 2-nitrophenyl group is a C₆ aromatic radical comprising a nitro group, the nitro group being a functional group. Aromatic radicals include halogenated aromatic radicals such as trifluoromethylphenyl, hexafluoroisopropylidenebis(4-phen-1-yloxy) (i.e. -OPhC(CF₃)₂PhO-), chloromethylphenyl; 3-trifluorovinyl-2-thienyl; 3-trichloromethylphen-1-yl (i.e. 3-CCl₃Ph-), 4(3-bromoprop-1-yl)phen-1-yl (i.e. BrCH₂CH₂CH₂Ph-), and the like. Further examples of aromatic radicals include 4-allyloxyphen-1-oxy, 4-aminophen-1-yl (i.e. H₂NPh-), 3-aminocarbonylphen-1-yl (i.e. NH₂COPh-), 4-benzoylphen-1-yl, dicyanoisopropylidenebis(4-phen-1-yloxy) (i.e. - OPhC(CN)₂PhO-), 3-methylphen-1-yl, methylenebis(phen-4-yloxy) (i.e. - OPhCH₂PhO-), 2-ethylphen-1-yl, phenylethenyl, 3-formyl-2-thienyl, 2-hexyl-5-furanyl; hexamethylene-1,6-bis(phen-4-yloxy) (i.e. -OPh(CH₂)₆PhO-); 4-hydroxymethylphen-1-yl (i.e. 4-HOCH₂Ph-), 4-mercaptomethylphen-1-yl (i.e. 4-HSCH₂Ph-), 4-methylthiophen-1-yl (i.e. 4-CH₃SPh-), 3-methoxyphen-1-yl, 2-methoxycarbonylphen-1-yloxy (e.g. methyl salicyl), 2-nitromethylphen-1-yl (i.e. -PhCH₂NO₂), 3-trimethylsilylphen-1-yl, 4-t-butyldimethylsilylphenl-1-yl, 4-vinylphen-1-yl, vinylidenebis(phenyl), and the like. The term "a C₃ - C₁₀ aromatic radical" includes aromatic radicals containing at least three but no more than 10 carbon atoms. The aromatic radical 1-imidazolyl (C₃H₂N₂-) represents a C₃ aromatic radical. The benzyl radical (C₇H₈-) represents a C₇ aromatic radical.

As used herein the term "cycloaliphatic radical" refers to a radical having a valence of at least one, and comprising an array of atoms which is cyclic but which is not aromatic. As defined herein a "cycloaliphatic radical" does not contain an aromatic group. A "cycloaliphatic radical" may comprise one or more noncyclic components. For example, a cyclohexylmethyl group (C₆H₁₁CH₂-) is a cycloaliphatic radical which comprises a cyclohexyl ring (the array of atoms which is cyclic but which is not aromatic) and a methylene group (the noncyclic component). The cycloaliphatic radical may include heteroatoms such as nitrogen, sulfur, selenium, silicon and oxygen, or may be composed exclusively of carbon and hydrogen. For convenience, the term "cycloaliphatic radical" is defined herein to encompass a wide range of functional groups such as alkyl groups, alkenyl groups, alkynyl groups, halo alkyl groups, conjugated dienyl groups, alcohol groups, ether groups, aldehyde groups, ketone groups, carboxylic acid groups, acyl groups (for example carboxylic acid derivatives such as esters and amides), amine groups, nitro groups and the like. For example, the 4-methylcyclopent-1-yl radical is a C₆ cycloaliphatic radical comprising a methyl group, the methyl group being a functional group which is an alkyl group. Similarly, the 2-nitrocyclobut-1-yl radical is a C₄ cycloaliphatic radical comprising a nitro group, the nitro group being a functional group. A cycloaliphatic radical may comprise one or more halogen atoms which may be the same or different. Halogen atoms include, for example; fluorine, chlorine, bromine, and iodine.

Cycloaliphatic radicals comprising one or more halogen atoms include 2-trifluoromethylcyclohex-1-yl, 4-bromodifluoromethylcyclooct-1-yl, 2-chlorodifluoromethylcyclohex-1-yl, hexafluoroisopropylidene2,2-bis (cyclohex-4-yl) (i.e. -C₆H₁₀C(CF₃)₂ C₆H₁₀-), 2-chloromethylcyclohex-1-yl; 3-difluoromethylenecyclohex-1-yl; 4-trichloromethylcyclohex-1-yloxy, 4-bromodichloromethylcyclohex-1-ylthio, 2-bromoethylcyclopent-1-yl, 2-bromopropylcyclohex-1-yloxy (e.g. CH₃CHBrCH₂C₆H₁₀-), and the like. Further examples of cycloaliphatic radicals include 4-allyloxycyclohex-1-yl, 4-aminocyclohex-1-yl (i.e. H₂NC₆H₁₀-), 4-aminocarbonylcyclopent-1-yl (i.e. NH₂COC₅H₈-), 4-acetyloxycyclohex-1-yl, 2,2-dicyanoisopropylidenebis(cyclohex-4-yloxy) (i.e. -OC₆H₁₀C(CN)₂CeH₁₀O-), 3-methylcyclohex-1-yl, methylenebis(cyclohex-4-yloxy) (i.e. - OC₆H₁₀CH₂C₆H₁₀O-), 1-ethylcyclobut-1-yl, cyclopropylethenyl, 3-formyl-2-terahydrofuranyl, 2-hexyl-5-tetrahydrofuranyl; hexamethylene-1,6-bis(cyclohex-4-yloxy) (i.e. -O C₆H₁₀(CH₂)₆C₆H₁₀O-); 4-hydroxymethylcyclohex-1-yl (i.e. 4-HOCH₂C₆H₁₀-), 4-mercaptomethylcyclohex-1-yl (i.e. 4-HSCH₂C₆H₁₀-), 4-methylthiocyclohex-1-yl (i.e. 4-CH₃SC₆H₁₀-), 4-methoxycyclohex-1-yl, 2-methoxycarbonylcyclohex-1-yloxy (2-CH₃OCOC₆H₁₀O-), 4-nitromethylcyclohex-1-yl (i.e. NO₂CH₂C₆H₁₀-), 3-trimethylsilylcyclohex-1-yl, 2-t-butyldimethylsilylcyclopent-1-yl, 4-trimethoxysilylethylcyclohex-1-yl (e.g. (CH₃O)₃SiCH₂CH₂C₆H₁₀-), 4-vinylcyclohexen-1-yl, vinylidenebis(cyclohexyl), and the like. The term "a C₃ - C₁₀ cycloaliphatic radical" includes cycloaliphatic radicals containing at least three but no more than 10 carbon atoms. The cycloaliphatic radical 2-tetrahydrofuranyl (C₄H₇O-) represents a C₄ cycloaliphatic radical. The cyclohexylmethyl radical (C₆H₁₁CH₂-) represents a C₇ cycloaliphatic radical.

As used herein, the term "electrooptic device" generally refers to a device which converts between electrical energy and light energy. That is, electrooptic devices typically convert both electrical energy into light energy, and light energy into electrical energy.

As used herein, the term "reduced organic material" means an organic material resulting from the corresponding neutral organic precursor accepting one or more electrons from an electron donor. The electron donor may also be referred to herein as a "reductant", and a "reducing agent". The reduced organic material can result from partial or complete reduction of the corresponding neutral organic precursor. The reduced organic material may be a reduced polymeric organic material (a "reduced polymeric species"), a reduced non-polymeric organic material, or a mixture thereof. Thus, the term "reduced polymeric species" refers to a reduced polymeric organic material which results when the corresponding reducible neutral polymeric organic precursor accepts one or more electrons from an electron donor. For convenience, the terms "reduced polymeric material", "reduced polymeric species" and "reduced polymeric organic material" may be used interchangeably herein, and each is sometimes referred to as an "anionic species". The reduced organic material may be a radical anion comprising a single additional electron relative to the corresponding reducible neutral organic precursor. Alternatively, the reduced organic material may be a dianion comprising two additional electrons relative to the corresponding reducible neutral organic precursor. Alternatively, the reduced organic material may be a radical polyanion comprising at least three additional electrons relative to the corresponding reducible neutral organic precursor. Alternatively, the reduced organic material may be a polyanion comprising a least four additional electrons relative to the corresponding reducible neutral organic precursor. Those skilled in the art will understand that a wide variety of radical anionic and anionic species are possible in reduced organic materials derived from neutral organic precursors capable of accepting multiple electrons. Thus, the term "reduced organic material" refers to both reduced polymeric organic materials and reduced non-polymeric organic materials and refers to at least one of a radical anionic species, a dianionic species, a radical polyanionic species, a polyanionic species, or a combination of two or more of the foregoing species. For example, the neutral polymeric organic precursor, poly vinyl naphthalene, which comprises multiple pendant naphthyl groups each of which is susceptible to reduction by an electron donor. upon acceptance of a single electron from a reducing agent such as potassium metal forms a reduced polymeric species comprising a naphthyl radical anion moiety. Addition of a second electron to the initially formed naphthyl radical anion moiety affords a reduced polymeric species comprising a naphthyl dianion moiety. Addition of a second electron to a naphthyl group other than the initially formed naphthyl radical anion moiety affords a reduced polymeric species comprising two naphthyl radical anion moieties. Those skilled in the art will understand that many different types and degrees of reduction are possible depending on the nature and number of the moieties capable of accepting one or more electrons from the reductant which are present in the neutral organic precursor. Other art recognized parameters such as the amount of reductant employed and the conditions under which the reduction is carried out will affect the degree of reduction. In one embodiment, the neutral organic precursor is said to be "partially reduced" and the product reduced organic material is said to be the product of "partial reduction". The radical anion resulting from the addition of a single electron to a poly vinyl naphthalene having a degree of polymerization (DP) of 1000 is an example of a "partially reduced" reduced polymeric organic material since addition of a second electron to the radical anion moiety or to another naphthyl group within the polymer chain is possible and likely, provided additional reductant is present. In another embodiment, the reduced organic material is said to be "completely reduced". That is, complete reduction of the corresponding reducible neutral organic precursor has occurred and the acceptance of an additional electron by the reduced organic material undergoing reduction is unlikely in the presence of additional reductant. The dianion of benzophenone, the product of the acceptance by neutral benzophenone of two electrons from a reductant such as sodium exemplifies a "completely reduced" reduced organic material since acceptance of an additional electron by the dianion is unlikely even in the presence of additional reductant. Although it is generally not possible to predict in advance at which point a neutral organic precursor such as the poly vinyl naphthalene having a degree of polymerization (DP) of 1000 will have accepted a sufficient number of electrons to render the acceptance of one additional electron unlikely in the presence of additional reductant, the point at which the reduced polymer is effectively "completely reduced" may be determined by experiment.

The term "neutral organic precursor" refers to a neutral organic material which is susceptible to accepting at least one electron from a reductant (i.e. is reducible). The neutral organic precursor may be a neutral polymeric organic precursor, typically a polymer comprising at least one aromatic radical. Or, the neutral organic precursor may be a neutral non-polymeric organic precursor, typically a non-polymeric material comprising at least one aromatic radical. In one embodiment, the neutral organic precursor is a mixture of a neutral polymeric organic precursor and a neutral non-polymeric organic precursor Typically, the neutral organic precursor comprises at least one organic group which is susceptible to accepting at least one electron from a reductant, said organic group possessing two or more conjugated double bonds. The organic group possessing two or more conjugated double bonds present in the neutral organic precursor may include heteroatoms either within the framework of the conjugated double bonds or as a component of a substituent appended to the organic group comprising the conjugated double bonds. As defined herein, any aromatic radical possesses at least one organic group possessing two or more conjugated double bonds. In various embodiments, the neutral organic precursor is a polymeric precursor having one or more types of repeat units in the polymer chain, for example a copolymer of styrene and vinyl naphthalene. In other embodiments the neutral organic precursor is a non-polymeric precursor, such as a small molecule precursor, for example benzophenone.

As used herein, the notation " 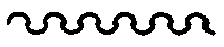 " as applied to the various structures for the reduced polymeric species and the corresponding reducible neutral polymeric precursors indicates an organic group. The organic group may also be part of a polymer chain or may represent a polymer chain. It may also include one or more heteroatoms, such as nitrogen, oxygen, sulfur, selenium, etc. For example, the meaning of the notation "N 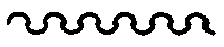 " include any organic group or polymer chain attached to a trivalent nitrogen atom .

In one aspect of the invention, an electrooptic device having at least a first conductive layer, a second conductive layer, and a first organic electro-active layer disposed between the first and second conductive layers, wherein the first organic electro-active material comprises a reduced organic material, is provided. In another aspect of the invention, a surface modified electrode comprising at least one conductive layer and at least one reduced organic material suitable for use in electronic devices, such as optoelectronic devices is provided. In one embodiment of the present invention, the surface modified electrode comprises at least one conductive layer and at least one reduced polymeric organic material. The reduced polymeric organic material comprises at least one additional electron relative to a corresponding neutral polymeric organic precursor. The reduced polymeric organic material is capable of enhancing the donation or transfer of a charge from one material to an adjacent material. The electro-active layer of the electrooptic device comprises a first organic electro-active material, which comprises a reduced organic material. Reduced organic materials include reduced polymeric organic materials and reduced non-polymeric organic materials obtained from the corresponding neutral polymeric organic precursors and neutral non-polymeric organic precursors, respectively. The reduced organic material is believed to enhance the donation or transfer of a charge from one material to an adjacent material within a device. In one embodiment, deposition of a reduced polymeric organic material on an electrode surface, such as aluminum or ITO (indium tin oxide) reduces the work function of the electrode surface. Further, the reduced work function persists after air exposure, which allows for sufficient work time to use the coated electrode surface in building electrooptic devices. In various embodiments of the present invention, resistance to air-induced loss of work function of the electrode surface can be achieved using copolymer forms of the corresponding neutral polymeric organic precursors, such as for example, a styrene - vinyl naphthalene copolymer.

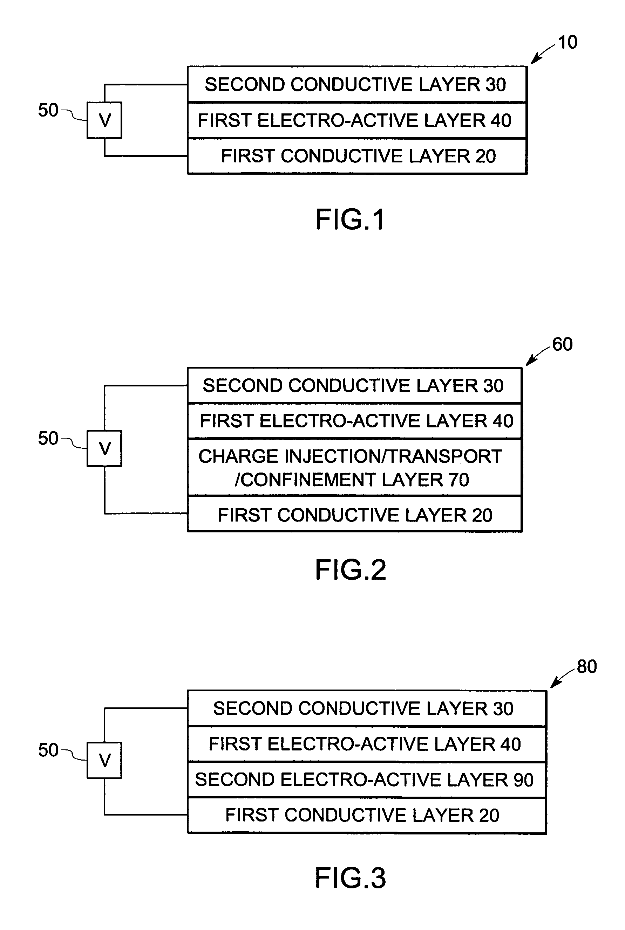

Further, the reduced polymeric species themselves can function as effective electro-active materials for conversion between electrical energy and light energy, which in an embodiment, makes these polymeric species more valuable for producing electrooptic devices. Figure 1 illustrates an embodiment of an electrooptic device 10 wherein the first organic electro-active material layer 40 is disposed between a first conductive layer 20 and a second conductive layer 30. When a voltage provided by source 50 is applied between the first and the second conductive layers (also hereinafter sometimes referred to as first and second electrodes, respectively), the electro-active layer 40 converts the electrical energy into light energy.

Suitable materials that can be used for the first and second conductive layers or the electrodes include metals, metal oxides, and electrically conductive polymers. Examples of conductive metal oxides include the well - known indium tin oxide (ITO) and other related materials. Conductive polymers having a system of conjugated double bonds to facilitate conduction of electrons can also be used. A wide variety of such conductive polymers are known in the art. Preferred conductive layers include at least one metal, at least one metal oxide, or combinations thereof.

The reduced organic material useful for forming the electro-active layer comprises at least one cationic species and at least one additional electron relative to a corresponding reducible neutral organic precursor. Suitable neutral organic precursors may be selected from neutral polymeric organic precursor materials and neutral non-polymeric organic precursor materials.

The reduced polymeric organic material is derived from the corresponding neutral polymeric organic precursor. In one embodiment, the neutral polymeric organic precursor includes at least one aromatic radical. In an example, the neutral polymeric organic precursor has pendant aromatic radicals located on the polymer chain (As in polystyrene, for example). In one embodiment, the reduced polymeric organic material is derived from a neutral polymeric organic precursor which has been subjected to reduction by a metallic species susceptible to giving up an electron. Alkali metals such as sodium metal (Na⁰), potassium metal (K⁰) are recognized by those skilled in the art as being susceptible to giving up an electron and are suitable reductants. In certain embodiments, the neutral polymeric organic precursor gives rise to the reduced polymeric organic material by an interaction of the neutral polymeric organic precursor with an atom or an ion of the metal. The term "interacting" or "interaction" includes accepting an electron from, capturing, holding, stabilizing in place, or otherwise forming a bond with a metal atom or ion. In one embodiment, the neutral polymeric organic precursor is capable of sharing electrons with, and stabilizing, a reduced metal (a metal in a negative oxidation state), a metal in a zero oxidation state, or a metal ion (a metal in a positive oxidation state). In another embodiment, the neutral polymeric organic precursor is a polarizable or an ionizable moiety. In still another embodiment, the neutral polymeric organic precursor is capable of forming a complex with the metal atom or ion.

Aromatic radicals, such as phenyl, phenylene, naphthyl, naphthylene, anthracenyl, and the like, are capable of accepting an electron from an electron donor metal species (atom or ion) to form a negatively charged radical anion species. The electron donor is usually a metal species, which after donating an electron to the neutral polymeric organic precursor remains and balances the charge or charges present in the reduced polymeric organic material. Whatever its source, the reduced polymeric organic material has at least one charge balancing cationic species. The cationic species may be a simple cation such as sodium ion (Na⁺) or may be a radical cation species, or a complex cation species. The cationic species present in the reduced polymeric organic material may also be generated from organic species, such as an organic species that is susceptible to giving up an electron to the neutral polymeric organic precursor thereby generating the reduced polymeric organic material and a radical cation. Non-limiting examples of organic species capable of forming radical cations in this manner include organic nitrogen compounds, e.g. tris(2,4,6-tribromophenyl)amine, and organic phosphorus compounds, e.g. tris(2,4,6-tribromophenyl)phosphine, which are transformed into nitrogen-centered and phosphorus-centered radical cations, respectively. The radical anions can be further reduced. For example, the neutral polymeric organic precursor can accept more than one electron to form an anionic species (e.g., dianionic species), a system having two or more radical anion moieties, or a system having a combination of one or more radical anion moieties and one or more dianion moieties. Non-limiting examples of electron donors include those selected from the group consisting of Group 1 metals, Group 2 metals, Group 3 metals, Group 4 metals, scandium, yttrium, rare earth metals, the lanthanide series of metals, and combinations thereof. It should be understood that the names of the Groups of the Periodic Table, as used herein, are those designated by the International Union of Pure and Applied Chemistry ("IUPAC"). Specific examples of suitable electron donors include lithium, sodium, potassium, cesium, calcium, magnesium, indium, tin, zirconium, europium, cerium, and aluminum.

The neutral polymeric organic precursor corresponding to the reduced polymeric organic material is generally a polymeric material comprising delocalized electrons, for example polymers comprising conjugated double bonds, polymers comprising conjugated triple bonds, and polymers comprising a combination of conjugated double and triple bonds. Frequently, the reduced polymeric organic material is conveniently prepared via the reduction of a neutral polymeric organic precursor comprising conjugated double bonds configured in one or more aromatic rings. While not wishing to be bound by any particular theory, it is believed that the reduced polymeric organic material functions as an electron transfer-promoting material that, in an embodiment, enhances electron injection from a cathode of an electrooptic device into an adjacent electroactive active material, that in an embodiment enhances electron injection from a cathode of an electrooptic device into an adjacent electroactive material layer. Electronically active materials are sometimes referred to as "electroluminescent materials" or "electro-active materials". A wide variety of neutral polymeric organic materials that can accept one or more electrons from an electron donor are known in the art. Suitable examples of such neutral polymeric organic materials as well as neutral non-polymeric organic materials include those disclosed by Akcelrud in "Electroluminescent Polymers", Progress in Polymer Science, Vol 28 (2003), pp. 875 - 962. These materials may include polymeric materials whose structures include various combinations of structures or structural units that are known either known in the art or are potentially expected to be electro-active, together with structures that are either known or are potentially expected to perform other functions important to enhance device performance, such as for example, hole transport, electron transport, charge transport, and charge confinement.

In one embodiment, the neutral polymeric organic precursor comprises structural units (1) 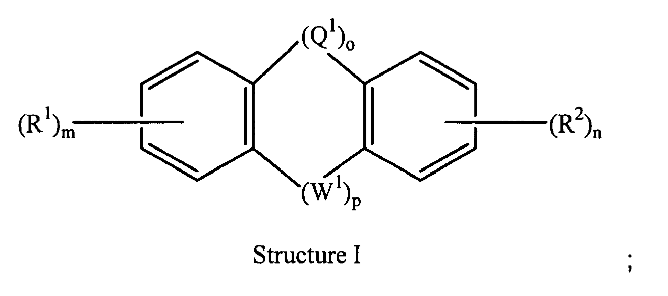 wherein R¹ and R² are independently at each occurrence a halogen atom, a C₁ - C₂₀ aliphatic radical, a C₂ - C₁₀ aromatic radical, a C₃ - C₁₀ cycloaliphatic radical, a nitro group, or a cyano group. The variables "m" and "n" are independently integers having values of 0 to 4 including the values 0 and 4. The variables "o" and "p" are independently integers having values of 0 to 1.

The sum of the values of the variables "o" + "p" is greater than 0. That is, not both "o" and "p" can be zero. W¹ is a bond, the group N 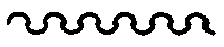 , an oxygen atom, a sulfur atom, a carbonyl group, the group C-R³, the group N-R³, or the group 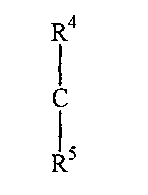 wherein R³, R⁴ and R⁵ are independently a hydrogen atom, a halogen atom, a polymer chain, a C₁ - C₂₀ aliphatic radical, a C₂ - C₁₀ aromatic radical, or a C₃ - C₁₀ cycloaliphatic radical. Q¹ is a bond, a carbonyl group, or the group 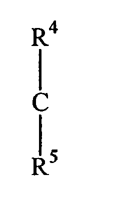 wherein R⁴ and R⁵ are independently a hydrogen atom, a halogen atom, a polymer chain, a C₁ - C₂₀ aliphatic radical, a C₂ - C₁₀ aromatic radical, or a C₃ - C₁₀ cycloaliphatic radical. In one embodiment, the notation "N 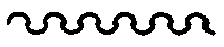 " denotes a trivalent nitrogen linked to a polymer chain (i.e. " 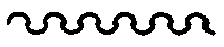 ") having a number average molecular weight in excess of 5,000 grams per mole. In an embodiment, one or more of the organic groups on the nitrogen can comprise heteroatoms, such as nitrogen, oxygen, sulfur, and selenium. Examples of neutral polymeric organic precursors comprising structural units (I) include (N-polystryrenyl)carbazole, a compound wherein "n" and "m" are zero, W¹ is a bond, and Q¹ is the group N-R³ wherein, R³ is a polymer chain comprising polystyrene. Additional examples of a neutral polymeric precursors comprising structural units (I) include poly(3-vinylanthracene) (m = 1, R¹ is a C₂ trivalent aliphatic radical, n= 0, Q¹= W¹ = C-R³ wherein R³ is hydrogen), poly(9-methyl-9-vinylxanthene) (m= n= 0, W^{l} is an oxygen atom, Q¹ is R⁴-C-R⁵ wherein R⁴ is a C₁-aliphatic radical (a methyl group) and R⁵ is a trivalent C₂ aliphatic radical (C₂H₃)), poly(3-ethynylanthracene), poly(3-ethynyl-9,9-dimethylxanthene), poly(3-vinyl-N-methylcarbazole), and the like.

In a second embodiment, the neutral polymeric organic precursor comprises structural units (II) 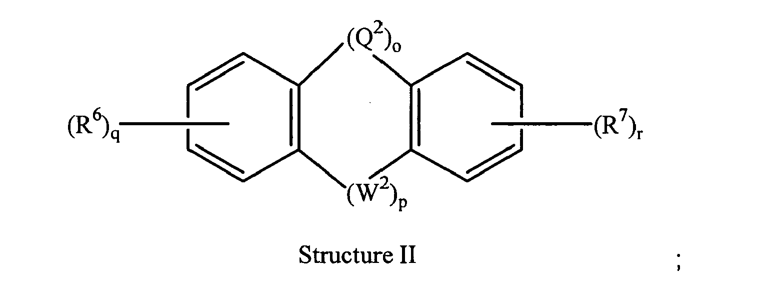 wherein R⁶ and R⁷ are independently at each occurrence a halogen atom, a C₁ - C₂₀ aliphatic radical, a C₂ - C₁₀ aromatic radical, a C₃ - C₁₀ cycloaliphatic radical, a nitro group, a cyano group, or a polymer chain ( 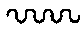 ). The variables "q" and "r" are independently inegers having values of 0 to 4 inclusive of the values 0 and 4. The sum of the values of "q" and "r" (q + r) is greater than 0. The variables "o" and "p" independently have values of 0 to 1; wherein o + p is greater than 0. W² is a bond, N 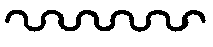 ; an oxygen atom, a sulfur atom, a carbonyl group, the group C-R³, the group N-R³, or the group 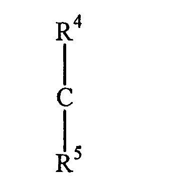 wherein R³, R⁴ and R⁵ are independently one of a hydrogen atom, a halogen atom, a polymer chain, a C₁ - C₂₀ aliphatic radical, a C₂ - C₁₀ aromatic radical, or a C₃ - C₁₀ cycloaliphatic radical. Q² is a bond, a carbonyl group, or a group selected from among the groups 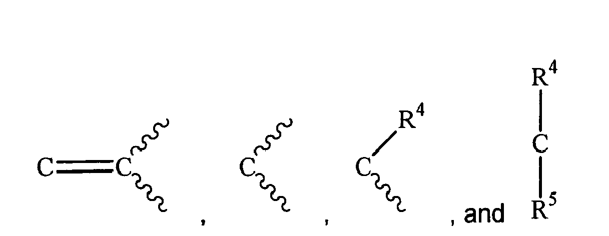 wherein R⁴ and R⁵ are independently a hydrogen atom, a halogen atom, a polymer chain, a C₁ - C₂₀ aliphatic radical, a C₂ - C₁₀ aromatic radical, or a C₃ - C₁₀ cycloaliphatic radical. Examples of neutral polymeric precursors comprising structural units (II) include polystyrene endcapped with 9,9-dimethylxanthene ("q" = 1, "r"=0, R⁶ is a polymer chain composed of polystyrene, o is 1, Q² = R⁴-C-R⁵ wherein R⁴ = R⁵ = a C₁-aliphatic radical (a methyl group)), p is 1 and W² is an oxygen atom.

In a third embodiment, the neutral polymeric organic precursor comprises structural units (III) 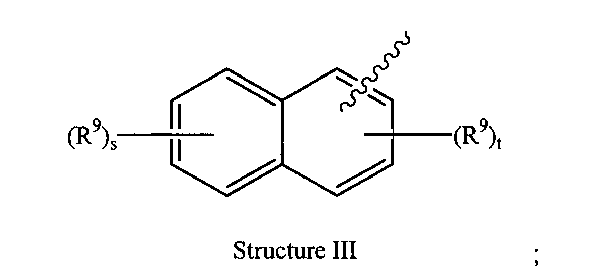 wherein R⁸ and R⁹ are independently at each occurrence a halogen atom, a C₁ - C₂₀ aliphatic radical, a C₂ - C₁₀ aromatic radical, a C₃ - C₁₀ cycloaliphatic radical, a nitro group, or a cyano group; "s" is an integer 0 to 4 including 0 and 4; and "t" is an integer 0 to 3 including 0 and 3. Examples of neutral polymeric precursors comprising structural units (III) include poly(1-vinylnapthalene), poly(2-vinylnapthalene), poly(2-vinylnapthalene-styrene) copolymer, and the like.

In a fourth embodiment, the neutral polymeric organic precursor comprises structural units (IV) 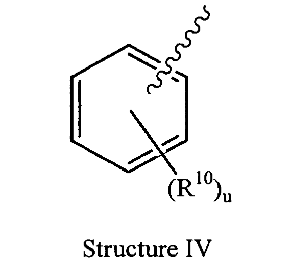 wherein R¹⁰ is independently at each occurrence a halogen atom, a C₁ - C₂₀ aliphatic radical, a C₂ - C₁₀ aromatic radical, a C₃ - C₁₀ cycloaliphatic radical, a nitro group, or a cyano group; and "u" is an integer 0 to 5 including 0 and 5. Examples of neutral polymeric organic precursors comprising structural units (IV) include polystyrene, poly(4-chlorostyrene), poly(4-phenylstyrene), poly(3-phenylstyrene), and the like.

In a fifth embodiment, the neutral polymeric organic precursor comprises structural units (V) 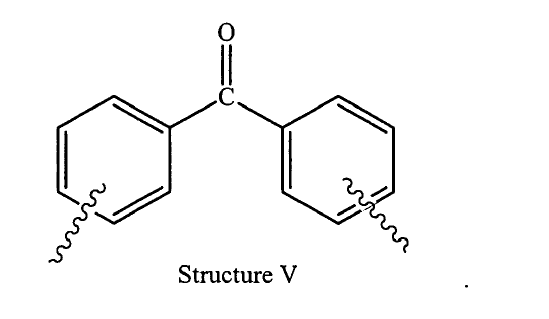 In a sixth embodiment, the neutral polymeric organic precursor comprises structural units (VI) 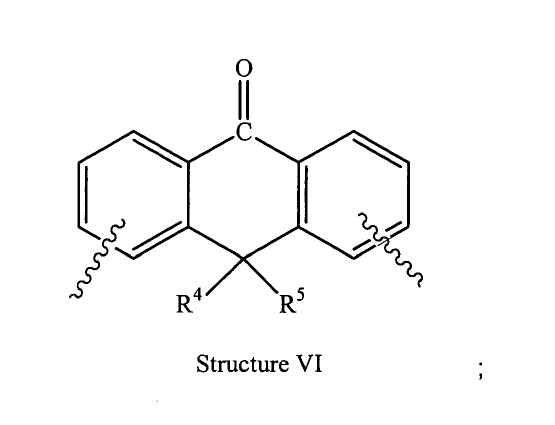 wherein R⁴ and R⁵ are independently a hydrogen, C₁ - C₂₀ aliphatic radical, a C₂ - C₁₀ aromatic radical, or a C₃ - C₁₀ cycloaliphatic radical. Non-limiting examples of aliphatic radicals include methyl, ethyl, propyl, butyl, isooctyl, and the like. Some examples of aromatic radicals include phenyl, alkylphenyl, naphthyl, and the like. Some examples of cycloaliphatic radicals include cyclohexyl, cyclopentyl, cyclohexylmethyl, and the like.

In a seventh embodiment, the neutral polymeric organic precursor comprises structural units (VII) 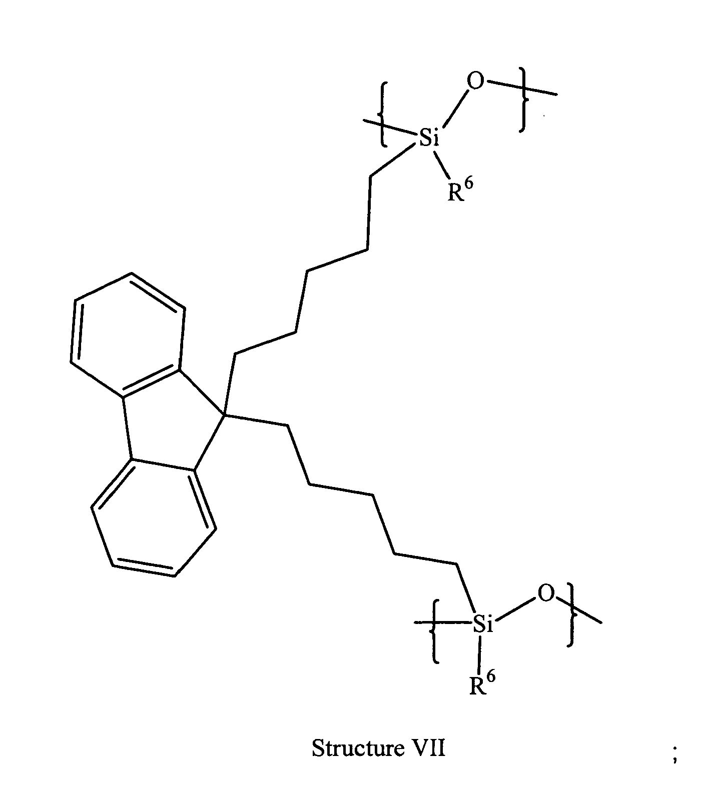 having siloxane repeat units, wherein R⁶ is independently at each occurrence a C₁ - C₂₀ aliphatic radical, a C₂ - C₁₀ aromatic radical, or a C₃ - C₁₀ cycloaliphatic radical.

In an eighth embodiment, the neutral polymeric organic precursor comprises structural units (VIII) 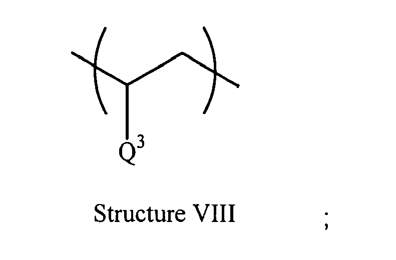 wherein Q³ is a naphthyl group or a binaphthyl group. Examples of neutral polymeric organic precursors comprising structural units (VIII) include poly(3-vinyl-1 ,1' -binapthalene), poly(2-vinyl-1,1'binapthalene), poly(2-vinylnapthalene-styrene) copolymer, and the like.

In a ninth embodiment, the neutral polymeric organic precursor comprises structural units (IX) 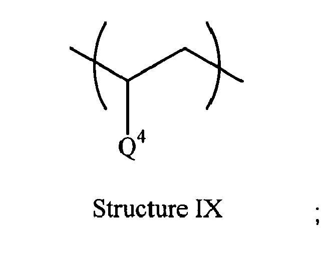 wherein Q⁴ is a phenyl group or a biphenyl group. Examples of neutral polymeric organic precursors comprising structural units (IX) include poly(4-vinyl-1,1'-biphenyl), poly(3-vinyl-1,1'-biphenyl), and the like.

In other embodiments, the neutral polymeric organic precursor comprises structural units derived from at least one polymerizable monomer. Examples of suitable polymerizable monomers include, but are not limited to vinyl naphthalene, styrene, vinyl anthracene, vinyl pentacene, vinyl chrysene, vinyl carbazole, vinyl thiophene, vinyl pyridine, (1,4-diethynyl)aromatics, such as (1,4-diethynyl)benzene; and combinations of the foregoing polymerizable monomers. Further, the polymerizable monomer may comprise one or more crosslinkable groups, such as, for example, vinyl groups, allyl groups, styryl groups, and alkynyl groups. Some examples of reducible neutral polymeric organic precursors are poly(3-hexylthiophene-2,5-diyl), and poly(fluorenyleneethynylene) polymers, such as those exemplified by structure X, 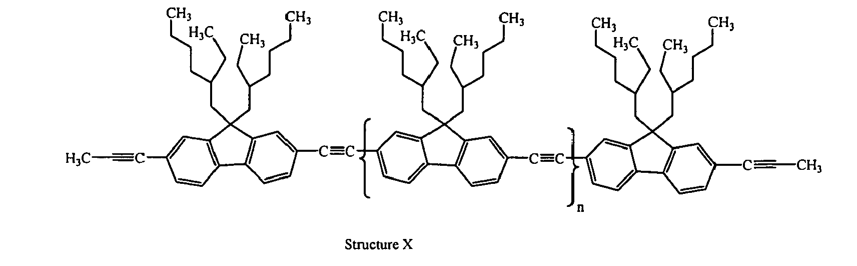 and poly(1,4-phenylenevinylene) polymers, such as for example, poly{[2-methoxy-5-(2'-ethylhexyloxy)]-1,4-phenylenevinylene}.

The neutral polymeric organic precursor may also comprise structural units derived from at least one organosilicon hydride, wherein the organosilicon hydride. Organosilicon hydrides are defined to comprise at least one Si-H bond. When organosilicon hydrides containing more than one Si-H bond, such as compounds comprising two or more organosilicon monohydride groups, organosilicon dihydride compounds, and organosilicon trihydride compounds are used, cross-linked polymeric materials may result. In an embodiment, the neutral polymeric precursor comprises structural units derived from at least one organosilicon hydride comprises at least one structural unit selected from the group consisting of structures XI, XII, and XIII.

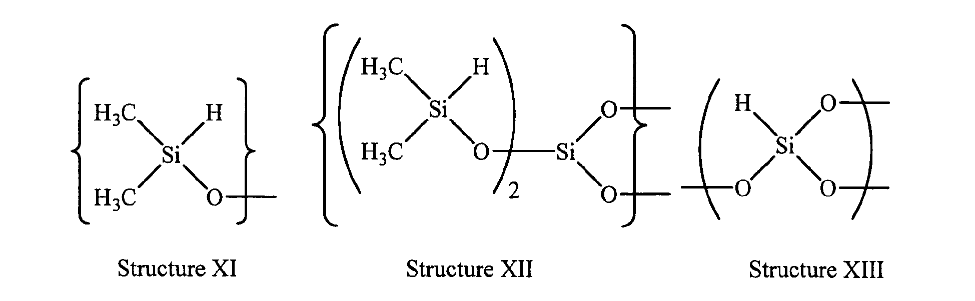

In a specific embodiment, the neutral polymeric organic precursor comprises structural units derived from at least one organosilicon hydride selected from the group consisting of (CH₃)₂Si(H)O-[Si(CH₃)₂O]ₓ-Si(CH₃)₂(H), and (CH₃)₃SiO-[SiCH₃(H)O]_{x'}-[Si(CH₃)₂O]_{y'}-Si(CH₃)₃; wherein x' and y' independently have values from about 1 to about 30.

The reduced polymeric organic materials may be prepared by contacting the corresponding neutral polymeric precursor with a metal (such as an alkali metal, for example, potassium)by reacting the metal in a suitable solvent, such as DME (1,2-dimethoxyethane), THF (tetrahydrofuran), nitromethane, halogenated hydrocarbons, DEE (ethyleneglycol diethylether), or xylenes. Solvent use may, in principle be avoided by contacting hot melts of the neutral polymeric precursors directly with the electron donor metal. Thus in an embodiment of the present invention, a coating composition comprising at least one reduced material (as described previously) and at least one polar aprotic solvent can be applied as a coating on an electrode surface using techniques known in the art. The modified electrode thus obtained can be used in producing EL devices.

The reduced organic material prepared as described above can also be used as electro-active materials for converting electrical energy into light energy and vice versa. Thus, such electro-active materials can be used as the electroluminescent layer in devices where electrical energy is converted into visible light energy. Further, such electro-active materials can also be used in photovoltaic devices for converting light energy into electrical energy.

Neutral organic precursors that can be reduced to form the first organic electro-active material are exemplified by polymeric fluorenyl compounds, such as the {poly[9,9-di(2-ethylhexyl)-fluorenyl-2,7-diyl] class of compounds. More particularly, {poly[9,9-di(2-ethylhexyl)-fluorenyl-2,7-diyl] end-capped by 3,5-dimethylphenyl groups (available commercially as ADS131 BE from American Dye Sources, Inc., Canada) may be used, either as such, or may be further purified if desired. ADS131 BE may be reduced with potassium metal in a suitable dipolar aprotic solvent to give a solution of potassium-ADS131 BE, which may be used for a variety of purposes. Since the potassium-ADS131 BE also improves electron injection from the cathode to an electro-active layer, it may be used as a coating agent for producing coated electrodes for electrooptic devices. It may also be used as an intrinsically electro-active material (i.e., the first organic electro-active material) for producing the electrooptic devices of the invention. Thus in an embodiment, an electrooptic device comprising a cathode, an anode, and an electro-active layer disposed between the cathode and the anode is provided; wherein the electro-active layer comprises a first organic electro-active material which is a reduced polyfluorene.

Other suitable neutral organic precursor materials include the neutral polymeric organic precursor material poly(vinylcarbazole) and the neutral organic precursor materials represented by trimer XIV and polymer XV.

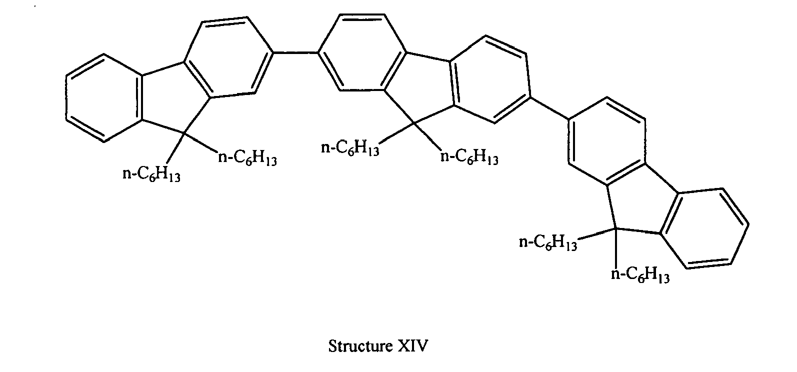

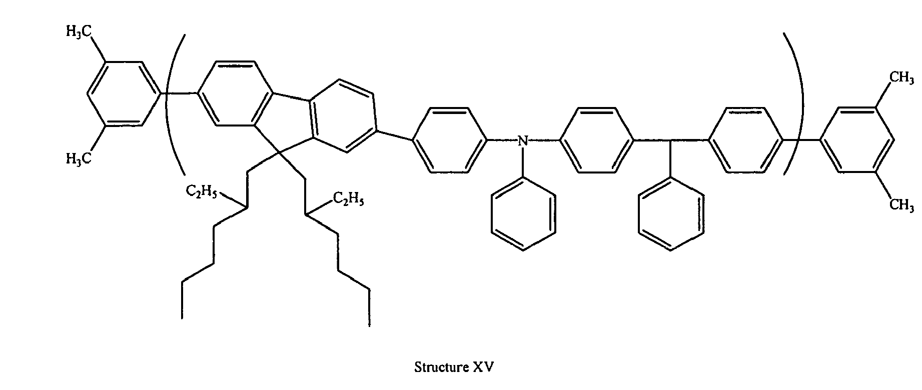

For each structures XIV and XV, the structure within parentheses indicates the repeat units of the polymeric material. The materials having structure XV is commercially available as ADS132 from American Dye Sources, Inc., Canada.

Evidence that compositions comprising reduced polymeric species may serve as the first organic electro-active material can garnered from their photoluminescence spectra, which show efficiencies comparable to those of the corresponding neutral organic electro-active material. For example, the photoluminescence spectra of films of ADS131 and films of the product obtained after treatment of ADS131 with potassium metal, a product which comprises the corresponding reduced polymeric species, show comparable spectral efficiency (as measured by integrating the spectral peaks), after applying a suitable correction factor to compensate for differences in film thickness. Moreover, the potassium-reduced ADS131 also shows improved electron injection performance, which helps improves device performance.

The reduced organic materials, particularly the reduced polymeric organic materials are valuable for producing electronic display devices. Without being limited by any theory, it is believed that such materials facilitate charge injection from an electron donor layer into an electronically active (or electroluminescent) material, and result in improved efficiency in the operation of the electronic display devices comprising such reduced polymeric organic materials. Further, since the reduced organic materials may by themselves be electro-active, such materials are even more useful for producing electronic display devices. Various configurations of the reduced organic material within an electrooptic device are useful in improving the efficiency of the device. For example, in one embodiment an organic electro-luminescent ("EL") device can benefit from a reduced organic material of the present invention disposed between the cathode and a layer comprising an organic electro-luminescent material. In another embodiment, an organic electro-active material comprises a reduced organic material and is disposed between a cathode and an anode, for example as illustrated in Figure 1. As in the case of conventional organic electro-luminescent materials, the organic electro-luminescent materials of the present invention comprising a reduced organic material (e.g. a reduced polymeric organic material) emit light under an applied voltage . The reduced organic material can be configured within a device such that it forms a distinct interface with an organic EL material, or a continuous transition region having a composition changing from a substantially pure reduced organic material to a substantially pure organic EL material.

In an embodiment, the reduced organic material can be deposited on an underlying material, such as an electrode or a conductive surface, by a method selected from the group consisting of spin coating, spray coating, dip coating, roller coating, or ink-jet printing.

In another exemplary embodiment, illustrated in Figure 2, the electrooptic device 60 is a stacked device comprising from bottom to top, a first conductive layer 20, a layer 70 comprising one of a charge injection, charge transport, or a charge confinement layer; a first organic electro-active material layer 40 comprising an electro-active reduced polymeric organic material of the invention, and a second conductive layer 30. Upon application of a voltage via source 50, the electrooptic device 60 emits light.

In yet another exemplary embodiment, illustrated in Figure 3, the electrooptic device 80 is a stacked device comprising from bottom to top, a first conductive layer 20, a first organic electro-active material layer 40 comprising a reduced organic material, a second organic electro-active material layer 90 comprising a reduced organic material, and a second conductive layer 30. Upon application of a voltage via source 50, the electrooptic device 80 emits light.
In an embodiment, the second organic electro-active material layer comprises a reduced organic material that is different from the reduced organic material present in the the first organic electro-active material layer. In another embodiment, the second organic electro-active material layer comprises an electro-luminescent neutral polymeric organic material, such as those known in the art for converting electrical energy into light energy. Such stacked devices offer the flexibility for tuning of the color of the light emitted from the overall light-emitting device.

The surface modified electrode provided by the present invention produced as described herein are valuable for forming electrooptic devices, which in an embodiment comprises a surface modified first electrode; a second electrode; and an electroluminescent organic material disposed between the first electrode and the second electrode; wherein the surface modified first electrode comprises at least one conductive layer, and at least one reduced polymeric organic material, said reduced polymeric organic material comprising at least one additional electron relative to a corresponding neutral polymeric organic precursor; and at least one cationic species. In an embodiment, at least one of the first or second electrodes may be transparent. The transparent electrode may have a percent light transmission of greater than or equal to about 90 percent in an embodiment, and greater than or equal to 95 percent in another embodiment. In one embodiment the present invention provides a light emitting device comprising at least one surface modified electrode, said surface modified electrode comprising an organic electro-active material which is electro-luminescent, said organic electro-active material comprising an reduced organic material which is electro-luminescent (e.g. an electro-luminescent reduced polymeric organic material).

The anode of an electrooptic device generally comprises a material having a high work function; e.g., greater than about 4.4 electron volts. Indium tin oxide ("ITO") is typically used for this purpose since it is substantially transparent to light transmission and allows light emitted from organic EL layer easily to escape through the ITO anode layer without being significantly attenuated. The term "substantially transparent" means allowing at least 50 percent, preferably at least 80 percent, and more preferably at least 90 percent, of light in the visible wavelength range transmitted through a film having a thickness of about 0.5 micrometer, at an incident angle of less than or equal to 10 degrees. Other materials suitable for use as the anode layer are tin oxide, indium oxide, zinc oxide, indium zinc oxide, zinc indium tin oxide, antimony oxide, and mixtures thereof. The anode layer may be deposited on the underlying element by physical vapor deposition, chemical vapor deposition, or sputtering. The thickness of an anode comprising such an electrically conducting oxide can be in the range from about 10 nanometers to about 500 nanometers, in an embodiment, from about 10 nanometers to about 200 nanometers in another embodiment, and from about 50 nanometers to about 200 nanometers in still another embodiment. A thin, substantially transparent layer of a metal, for example, having a thickness of less than about 50 nanometers, can also be used as a suitable conducting layer. Suitable metals for anode are those having a high work function, such as greater than about 4.4 electron volts, for example, silver, copper, tungsten, nickel, cobalt, iron, selenium, germanium, gold, platinum, aluminum, or mixtures thereof or alloys thereof. In one embodiment, it may be desirable to dispose the anode on a substantially transparent substrate, such as one comprising glass or a polymeric material.

The cathode injects negative charge carriers (electrons) into the electro-active layer and is made of a material having a low work function; e.g., less than about 4 electron volts. In an embodiment, the low-work function materials suitable for use as a cathode are metals, such as K, Li, Na, Cs, Mg, Ca, Sr, Ba, Al, Ag, In, Sn, Zn, Zr, Sc, Y, elements of the lanthanide series, alloys thereof, or mixtures thereof. Suitable alloy materials for the manufacture of cathode layer are Ag-Mg, Al-Li, In-Mg, and Al-Ca alloys. Layered non-alloy structures are also possible, such as a thin layer of a metal such as calcium, or a non-metal, such as LiF, covered by a thicker layer of some other metal, such as aluminum or silver. The cathode may be deposited on the underlying element by physical vapor deposition, chemical vapor deposition, or sputtering.

In one embodiment, when a reduced organic material is used to prepare a surface modified electrode contained within an organic electro-luminescent device, the organic electroluminescent layer is thought to serve as the transport medium for both holes and electrons. In an alternate embodiment, a reduced organic material is present in a first and/or the second organic electro-active material contained with a layer of an electro-luminescent device, and is thought to serve as transport media for both holes and electrons. A simple theoretical model for electro-luminescent devices depicts "holes" and electrons combining within an electro-active layer comprising an electro-luminescent material layer to give excited state species which drop to a lower energy level, concurrently emitting EM radiation in the visible range. In the various embodiments of the present invention in which an electro-luminescent device comprises both a first and a second organic electro-active material which are electro-luminescent, the first and a second organic electro-active materials may be selected such that the device produces light in a desired wavelength range. In one embodiment, the first and second electro-luminescent materials are configured within the device as separate layers, referred to as a first organic electro-active material layer and a second organic electro-active material layer respectively. The thickness of these layers is typically in the range of about 50 nanometers to about 300 nanometers. In one embodiment, either or both of the first and second organic electro-active material layers comprise a reduced organic material. In various embodiments, the organic EL materials present in a first electro-active layer comprises a reduced organic material and a second electro-active layer comprises only one or more neutral materials which may be a polymer, a copolymer, a mixture of polymers, or lower molecular-weight organic molecules having unsaturated bonds. Such materials possess a delocalized π-electron system, which gives the polymer chains or organic molecules the ability to support positive and negative charge carriers with high mobility. Suitable neutral polymers are poly(n-vinylcarbazole) ("PVK", emitting violet-to-blue light in the wavelengths of about 380-500 nanometers) and its derivatives; polyfluorene and its derivatives such as poly(alkylfluorene), for example poly(9,9-dihexylfluorene) (410-550 nanometers), poly(dioctylfluorene) (wavelength at peak EL emission of 436 nanometers), and poly{9,9-bis(3,6-dioxaheptyl)-fluorene-2,7-diyl} (400-550 nanometers); poly(paraphenylene) ("PPP") and its derivatives such as poly(2-decyloxy-1,4-phenylene) (400-550 nanometers), and poly(2,5-diheptyl-1,4-phenylene); poly(p-phenylene vinylene) ("PPV") and its derivatives such as dialkoxy-substituted PPV, and cyano-substituted PPV; polythiophene and its derivatives such as poly(3-alkylthiophene), poly(4,4'-dialkyl-2,2'-bithiophene), and poly(2,5-thienylene vinylene); poly(pyridine vinylene) and its derivatives; polyquinoxaline and its derivatives; and polyquinoline and its derivatives. Mixtures of these polymers or copolymers based on one or more of these polymers and others may be used to tune the color of emitted light.

Another class of suitable neutral polymers that are electroluminescent is the polysilanes. Polysilanes are linear silicon-backbone polymers substituted with a variety of alkyl and/or aryl side groups. They are quasi one-dimensional materials with delocalized sigma - conjugated electrons along polymer backbone chains. Examples of polysilanes are poly(di-n-butylsilane), poly(din-pentylsilane), poly(di-n-hexylsilane), poly(methylphenylsilane), and poly{bis(p-butylphenyl)silane} which are disclosed in H. Suzuki et al., "Near-Ultraviolet Electroluminescence From Polysilanes," 331 Thin Solid Films 64-70 (1998). These polysilanes emit light having wavelengths in the range from about 320 nanometers to about 420 nanometers.

Organic materials having molecular weight less than, for example, about 5000 grams per mole and comprising reducible aromatic units are also applicable for use as the organic electro-active material comprised with the electro-active layer. An example of such materials is 1,3,5-tris{n-(4-diphenylaminophenyl) phenylamino}benzene, which emits light in the wavelength range of 380-500 nanometers. In one embodiment, the electro-active layer may comprise a neutral organic EL material which is non-polymeric, for example lower molecular weight organic molecules, such as phenylanthracene, tetraarylethene, coumarin, rubrene, tetraphenylbutadiene, anthracene, perylene, coronene, or their derivatives. These materials generally emit light having maximum wavelength of about 520 nanometers. Still other suitable materials are metal organic complexes such as aluminum-, gallium-, and indium-acetylacetonate, which emit light in the wavelength range of 415-457 nanometers, aluminum-(picolymethylketone)-bis{2,6-di(t-butyl)phenoxide} or scandium-(4-methoxy-picolylmethylketone)-bis(acetylacetonate), which emits in the range of 420-433 nanometers. For white light applications, the preferred neutral organic EL materials are those emit light in the blue-green wavelengths.

Other suitable neutral organic EL materials that emit in the visible wavelength range are organometallic complexes of 8-hydroxyquinoline, such as tris(8-quinolinolato)aluminum and other materials disclosed in U. Mitschke and P. Bauerle, "The Electroluminescence of Organic Materials," J. Mater. Chem., Vol. 10, pp. 1471-1507 (2000).

One or more electro-active layers comprising an organic electro-active material, for example an organic EL layer, may be formed successively one on top of another, each layer comprising a different organic EL material that emits in a different wavelength range. Such a construction can facilitate a tuning of the color of the light emitted from the overall light-emitting device. In one embodiment, the present invention provides an electro-luminescent device comprising multiple electro-luminescent layers at least one of which comprises a reduced organic material.

In one embodiment, the electrooptic device of the present invention comprises one or more layers in addition to those previously discussed herein, which may be included in the device to further increase its efficiency. For example, the efficiency of an EL device may be enhanced by the inclusion of an additional layer which improves the injection and/or transport of positive charges ("holes") into the organic EL layer. The thickness of each of these layers is typically less than 500 nanometers, preferably less than 100 nanometers. Suitable materials for these additional layers are low-to-intermediate molecular weight (for example, less than about 2000 grams per mole) organic molecules, poly(3,4-ethylenedioxythipohene) doped with polystyrene sulfonate acid ("PEDOT:PSS"), and polyaniline. They may be applied during the manufacture of the device by conventional methods such as spray coating, dip coating, or physical or chemical vapor deposition. In one embodiment of the present invention, a hole injection enhancement layer can be introduced between the anode layer and the organic EL layer to provide a higher injected current at a given forward bias and/or a higher maximum current before the failure of the device. Thus, the hole injection enhancement layer facilitates the injection of holes from the anode. Suitable materials for the hole injection enhancement layer are arylene-based compounds, such as 3,4,9,10-perylenetetra-carboxylic dianhydride or bis(1,2,5-thiadiazolo)-p-quinobis(1,3-dithiole) disclosed in U.S. Patent 5,998,803.

In one embodiment, the present invention provides a light emitting electrooptic device which includes a hole transport layer disposed between a hole injection enhancement layer and an electro-luminescent first organic electro-active layer. The hole transport layer transports holes and blocks the transportation of electrons so that holes and electrons are optimally combined in the organic EL layer. Exemplary materials suitable for the hole transport layer include triaryldiamine, tetraphenyldiamine, aromatic tertiary amines, hydrazone derivatives, carbazole derivatives, triazole derivatives, imidazole derivatives, oxadiazole derivatives having an amino group, and polythiophenes as disclosed in U.S. Patent 6,023,371.

In other embodiments, the present invention provides an electrooptic device comprising an "electron injecting and/or transporting enhancement layer" or a "charge injecting and/or transport enhancement layer" as an additional layer, which can be disposed between the electron-donating material and the organic EL layer in one embodiment, and between the first conductive layer 20 and the first electro-active layer 40, as illustrated in Figure 2. Materials suitable for the electron injecting and/or transporting enhancement layer are metal organic complexes such as tris(8-quinolinolato)aluminum, oxadiazole derivatives, perylene derivatives, pyridine derivatives, pyrimidine derivatives, quinoline derivatives, quinoxaline derivatives, diphenylquinone derivatives, and nitro-substituted fluorene derivatives, as disclosed in U.S. Patent 6,023,371.

In one embodiment, the present invention provides an electrooptic device comprising one or more charge blocking or charge confinement layers. An exemplary charge confinement layer material is shown in structure XVI, (also abbreviated as "poly(TPD)", available commercially)

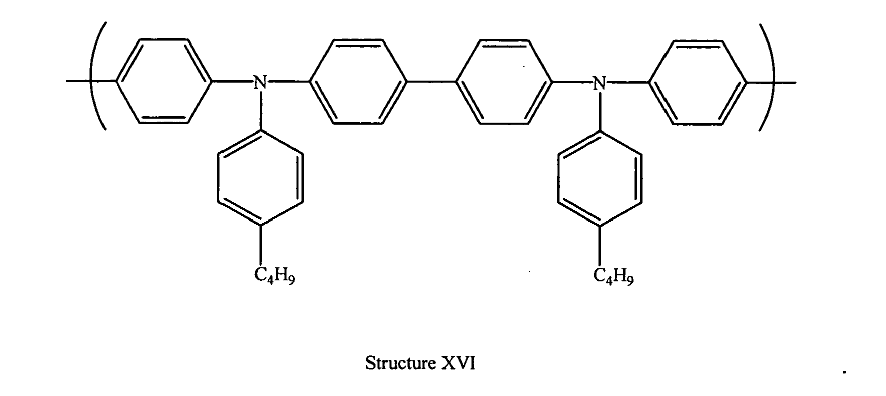

Although electrooptic devices having various types of charge transport and/or hole transport layers can be used in conjunction with the reduced organic materials as organic electro-active materials, as described herein, it is also possible to form electrooptic devices consisting essentially of a first conductive layer a second conductive layer, and an electro-active layer disposed between the first and second conductive layers, wherein the electro-active layer comprises an organic electro-active material, the organic electro-active comprising a reduced organic material. Such devices may also be sometimes referred to as "single layer devices" since the device contains a single layer of an organic electro-active material.

In one embodiment the present invention provides a light-emitting device comprising a reduced organic material and one or more photoluminescent ("PL") layers, having at least a fluorescent layer and/or a phosphorescent layer, such as, for example those disclosed in U.S. Patent 6, 847,162.

In another embodiment the present invention provides an opto-electronic device which is a photovoltaic ("PV") cell comprising a reduced organic material. The reduced organic material enhances the performance of the PV cell by the efficient transport of electrons across an interface between an electrode and an adjacent EL - active material.

In one aspect the present invention provides a method for fabricating an electrooptic device. The method comprises (a) disposing a layer of an electro-active material between a first conductive layer and a second conductive layer to form the electrooptic device, wherein the electro-active material comprises a first organic electro-active material, the first organic electro-active material comprising a reduced organic material.

In an alternate embodiment, the present invention provides a method for the preparation of an optoelectronic device, said method comprising: (a) providing a surface-modified first electrode (prepared as described previously in this disclosure); (b) disposing on the surface-modified first electrode a charge transfer-promoting material; (c) disposing on the charge transfer-promoting material an organic electro-active material (for example an EL organic material); and (d) providing a second electrode on the organic electro-active material. In another embodiment, the present invention provides a method for the preparation of an electrooptic device, said method comprising (a) providing a first conductive layer, such as a cathode, (b) disposing a layer of a first organic electro-active material comprising a reduced polymeric organic material on the first conductive layer, and (c) disposing a second conductive layer, such as an anode layer on the electro-active material layer.

Useful devices that can be produced using the surface modified electrodes and organic electro-active materials comprising the reduced organic materials of the present invention include organic photovoltaic devices, photodetectors, display devices, and organic light emitting devices. Display devices are exemplified by devices used for producing signage and other uses. Thus, in an embodiment, a display device is provided, where the display includes a plurality of electrooptic devices, which devices comprise at least one reduced polymeric materials described herein. The electrooptic devices assembled using the methods provided by the present invention are easy to operate. In an embodiment, the method includes applying an electrical field or light energy to the electrooptic device. In one embodiment, the first organic electro-active material of the invention converts electrical energy to light energy. In an alternate embodiment a first organic electro-active material convers light energy to electrical energy , such as in a photovoltaic device.

It should be emphasized that the electrooptic devices provided by the present invention may be utilized in an almost unlimited variety of applications and products such as lighting and signage applications, and products which include computer and graphic displays, signs, photo detectors, and the like.

In a further embodiment the present invention provides an electrooptic device comprising (a) a first conductive layer; (b) a second conductive layer; and (c) an electro-active layer disposed between the first and second conductive layers, wherein the electro-active layer comprises a first organic electro-active material, said first organic electro-active material having been prepared by a method comprising a step of contacting a neutral organic precursor with a reducing agent capable of transferring at least one electron to the neutral organic precursor. As noted elsewhere herein, suitable reducing agents which may be used during said contacting include alkali metals and alkaline earth metals such as sodium, potassium, and calcium. Typically the contacting involves combining the reducing agent (e.g. sodium metal) with the neutral organic precursor in a solvent at a temperature between about 0 °C and about 150 °C for a period of from about thirty seconds to about 30 hours. Suitable solvents include aliphatic ether solvents, cycloaliphatic ether solvents, and aromatic solvents. Aliphatic ether solvents are illustrated by DME, polyethylene glycol dimethyl ether, diethyl ether, and the like. Cycloaliphatic ether solvents are illustrated by tetrahydrofuran, N-methylmorpholine, dioxane, and the like. Aromatic solvents are illustrated by toluene, xylene, anisole, and the like. In one embodiment, the first organic electro-active material is selected from the group consisting of polymeric organic electro-active materials.

### EXAMPLES

The following examples are set forth to provide those of ordinary skill in the art with a detailed description of how the methods claimed herein are evaluated, and are not intended to limit the scope of what the inventors regard as their invention. Unless indicated otherwise, parts are by weight, temperature is in °C. The unit for CPD is volt (V), and the unit for effective work function is electron volt (eV). Generally, the greater the CPD, the lower the effective work function. Solvents were dried by distillation from potassium and stored over activated sieves.

### Example 1

This Example demonstrates the use of a styrene-vinylnaphthalene copolymer (abbreviated as "Naphstyr") in preparing a reduced polymeric organic material which reduced the work function of aluminum electrode surface by 0.66 electron volts.

A 1: 1 copolymer of styrene and vinylnaphthalene was prepared using styrene (1 gram), vinylnaphthalene (1.3 grams), and AIBN (azobis(isobutyronitrile, 50 milligrams) initiator in toluene. The polymerization was carried out by degassing the mixture and heating the mixture at a temperature of 130 °C for 14 hours. After heating, the solid was dissolved in dichloromethane and then precipitated by addition of methanol. The precipitate was isolated, redissolved in dichloromethane, and then re-precipitated into methanol. The final product was recovered by filtration, washed with methanol, and dried *in vacuo* to yield 0.44 grams of the desired product as a solid. Gel permeation chromatography analysis showed the polymer to have a number average molecular weight (Mₙ) of 22,000, and a weight average molecular weight (M_{w}) of 56,000.

A 0.1 gram portion of the copolymer obtained above was dissolved in 5 milliliters of dry ethyleneglycol dimethyl ether (DME). The resulting solution was subjected to three freeze/degas/thaw cycles, and then stirred at ambient temperature with potassium metal (59 milligrams). A green solution of naphthstyr - K was obtained after stirring for 1 - 2 hours. The solution was spin coated (at 4000 revolutions per minute) onto Al-glass in a glove box. Kelvin probe analysis of the Al/Naphstyr - K showed a contact potential difference (CPD) of 1.76 volts. The CPD of AI-glass is 1.1 volts, thus giving a lowering of effective work function of 0.66 eV. After being exposed to air for about 1 minute, the CPD was measured again, and was found to be unchanged at 1.76 volts.

### Example 2.

The procedure of Example 1 was repeated, except that the spin coating of the Naphthstyr-K solution in DME was done at 1000 revolutions per minute. Initial Kelvin probe measurement of the surface modified electrode showed a work function value of 1.82 V. After being exposed to air for about 1 minute, the Kelvin probe value was unchanged. The surface modified electrode was left exposed to ambient air overnight. Kelvin probe measurement carried out on the next day showed a CPD value of 1.38 V, which was still 0.2 volt higher than that (1.18 volts) of the Al-glass control sample, indicating a reduction in effective work function of 0.2 electron volt.

### Example 3.

This Example demonstrates the use of poly(vinylnaphthalene) in preparing a reduced polymeric organic material which reduced the effective work function of aluminum electrode surface by 0.42 electron volts.

Poly(vinylnaphthalene) was prepared by free-radical polymerization with AIBN initiator in toluene. The product was purified by two precipitations from methanol/methylene chloride solvent mixture. The purified polymer had a M_{w} of 9230, a Mₙ of 4332, and a M_{w}/Mₙ of 2.13.

Potassium reduction of polyvinylnaphthalene in THF gave a dark solution. This material (K - polyNaph) was spin coated onto Al/glass in the glove box.

Kelvin probe analysis showed a work function of 1.53 V (versus I.11 V for the control Al-glass). After a 1 - minute air exposure, Kelvin probe showed a CPD value of 1.48 volts. After exposure to air for 24 hours, the Kelvin probe showed a CPD value of 1.21 volts.

The results from Examples 1 - 3 shows that the reduced polymeric organic material comprising reduced phenyl and/or naphthyl pendant groups imparts a lower work function and some resistance to re-oxidation by air.

### Example 4.

Commercial polyvinyl carbazole (PVK) was dissolved in THF and then reduced with potassium to give a dark blue solution. The K - PVK solution was spin coated onto Al/glass. Kelvin probe analysis showed a CPD value of 1.42 V.

### Example 5.

This Example demonstrates the synthesis of a neutral polymeric organic precursor prepared by reaction of 9,9-di(5-hexenyl)fluorene with M(D^{H})₄D₁₅M [Me₃SiO-(MeSiHO)₄-(SiMe₂-O)₁₅-OsiMe₃].

Fluorene (5grams, 30.1 millimoles), and -bromo-5-hexene (15.7grams, 64 millimoles) were combined with 50 milliliters of dimethyl sulfoxide (DMSO) and 50 milliliters of 50 percent aqueous sodium hydroxide solution, and heated to about 120 °C for 14 hours. After being cooled to ambient temperature, the reaction mixture contained three layers, which were separated using a separatory funnel. The top-most layer was yellow, the middle layer was pink and the bottom layer was milky white. The bottom layer was removed, and the two top organic layers were washed with saturated sodium chloride solution. Addition of the aqueous sodium chloride solution caused loss of the pink color. A yellow organic layer resulted, which was separated and subjected to vacuum distillation to remove DMSO and un-reacted n-hexyl bromide. GC analysis of the residual material in the distillation flask showed it to be a mixture of greater than 90 weight percent of 9,9-di(5-hexenyl)fluorene and less than 10 weight percent of 9-(5-hexenyl)fluorene, respectively. Complete consumption of fluorene was also deduced. The assay of the desired product by gas chromatography and proton NMR analysis showed it to be composed of 92 percent of 9,9-di(5-hexenyl)fluorene.

### Example 6.

This Example describes the preparation of a hydrosilylation product corresponding to a 1 : 2 relative mole ratio of olefin groups of 9,9-di(5-hexenyl)fluorene and Si-H groups of M(D^{H})₄D₁₅M, respectively.

A solution of 9,9-di(5-hexenyl)fluorene (0.124 gram, 0.376 millimole) was prepared in DME (5 milliliters). A 1 milliliter portion of this solution was combined with GE Silicones intermediates 88405 (having formula M(D^{H})₄D₁₅M, 0.12 gram) and Karstedt's platinum catalyst (1 microliter of a 5 weight percent solution in xylenes) to obtain a Si-H/olefin mole ratio of 2 : 1, respectively. The hydrosilylation reaction was followed by proton NMR spectroscopy. After heating at 80 °C for 1 hour, spectral analysis showed complete consumption of all the olefin groups. The resulting product was the desired cross-linked hydrosilylated product.

### Example 7.

This Example describes the preparation of a hydrosilylation product corresponding to a 1 : 1 relative mole ratio of olefin groups of 9,9-di(5-hexenyl)fluorene and M(D^{H})₄D₁₅M, respectively.

A solution of 9,9-di(5-hexenyl)fluorene (0.124 gram, 0.376 millimole) was prepared in DME (5 milliliters). A 1 milliliter portion of this solution was combined with GE Silicones intermediates 88405 (having formula M(D^{H})₄D₁₅M, 0.06 gram) and Karstedt's platinum catalyst (1 microliter of a 5 weight percent solution in xylenes) to obtain a Si-H groups/olefin groups mole ratio of 1 : 1, respectively. The hydrosilylation reaction was followed by proton NMR spectroscopy. After heating at 80 °C for 1 hour, spectral analysis showed complete consumption of all the olefin groups. The resulting product was the desired cross-linked hydrosilylated product.

### Example 8.

This Example describes the preparation of the reduced polymeric organic material derived from the neutral polymeric organic precursor prepared above in Example 7.

A blue solution of potassium-9,9-di(n-hexyl5-hexenyl)fluorene, prepared as described below in Example 11 (1 milliliter DME solution) was added to a vial that contained 1 microliter of the Karstedt platinum catalyst solution as described above. This solution was then added to a second vial that contained M(D^{H})₄D₁ₛM (0.058 gram). The blue color changed to red after addition to M(D^{H})₄D₁₅M polymer containing Si-H bonds. The combined solution was then spin coated onto Al - glass at 4000 revolutions per minute in a dry box. The slide was then heated at 90°C for 1 hour. Kelvin probe analysis showed a CPD value 1.45 V. The slide was then exposed to air for about 1 minute. The new CPD value after air exposure was 1.26 V, still about 0.3 V volts higher (or equivalently, 0.3 electron volts reduction in effective work function) compared to that of the Al control measured prior to the coating. Finally, the film-coated slide was subjected to a Scotch Tape pull test, and then the CPD value was measured again. The CPD value remained unchanged at 1.26 V.

The results from Example 8 taken together with those shown in the Examples 12 and 13 (described below) demonstrates that the coating of the cross-linked organosilicon reduced polymeric species has good adhesion to the aluminum surface even after being heated to 90 °C.

Examples 9 and 10.

Sodium benzophenone ketyl and potassium benzophenone ketyl were prepared by treatment of benzophenone (0.1 gram) with two molar equivalents of sodium and potassium, respectively, and stirring at ambient temperature for about 1 hour. The resulting solutions were spin coated on Al-glass to produce the corresponding surface-modified electrodes. CPD measurements showed that both modified electrodes had lower work functions relative to Al-glass. Thus, the CPD value for the sodium benzophenone ketyl coated electrode was 1.34 V. However, after air exposure for about 1 minute, the CPD decreased immediately to 1.006 V, compared to the 1.18 eV value observed for the control Al-glass. Similarly, the CPD value for potassium benzophenone ketyl coated electrode was 1.87 V, but brief exposure to air caused this value to rise to 1.2 V, almost the same as the CPD of the control sample.

### Example 11.

This Example illustrates the results obtained with coating Al-glass sample with a coating solution containing potassium-9,9-di(n-hexenyl)fluorene.

In a Schlenk flask, 9,9-di(n-hexyl)fluorene (0.12 gram, 0.36 millimole), prepared as described in Example 5 was dissolved in 5 milliliters of dry DME and then potassium (0.034 gram, 0.87 millimole) was added. The mixture was then subjected to three freeze - degas - thaw cycles, and then stirred at ambient temperature. The solution turned blue within 45 min. The blue solution was spin coated onto Al/glass in a glove box at 4000 rpm (revolutions per minute). Kelvin probe measurement of blank Al/glass had a CPD (contact potential difference) value of 0.87 V. The Al/glass piece coated with the blue solution had a CPD value of 1.76 V, or a lowering of the effective work function by over 0.8 electron volts

### Example 12.

A solution of DME with M(D^{H})₄D₁₅M and platinum catalyst was spin coated onto Al/glass at 4000 rpm and then heated at 90°C for 1 hour. The CPD value was 0.98 V.

### Example 13.

A DME solution of 9,9-di(n-hexyl)fluorene, platinum catalyst and M(D^{H})₄D₁₅M was spin-coated and heated as before. The CPD value was 1.13 V.

Examples 9-13 demonstrate that improvements in the electrode work function can be achieved even when the reduced organic material used to modify the electrode is not polymeric.

### Example 14.

ADS131 BE was used as received without any further purification. In a Schlenk tube equipped with a gas inlet and a magnetic stir bar, and taken directly from the oven was placed 0.01 grams of ADS131 BE, and 0.01 gram of potassium. To this mixture was added 5 milliliters of tetrahydrofuran (or ethyleneglycol dimethyl ether) via a syringe, and the mixture was stirred and subjected to three freeze-degas-thaw cycles using a vacuum line. The mixture was warmed to ambient temperature with continued stirring. A blue color was noted within 2 - 6 hours. Then resulting solution was stored in a glove box wherein the moisture level was less than about 1 part per million, and the oxygen level was less than about 10 parts per million. Polymer films were spin-coated in the same glove box using the DME solution of the reduced ADS131 BE onto a pre-cleaned quartz substrate. The coated quartz substrate was sealed with another quartz substrate layer at the perimeter with an optical adhesive. UV-visible absorption measurements were conducted with an HP8254 Photodiode array spectrometer. Photoluminescence spectra were measured using a Spex Fluorolog-2 double grating spectrofluorometer. The procedure described above was repeated with un-reduced ADS131 BE. The PL intensity was corrected with in-line absorption at the excitation wavelength to compensate for the difference in film thickness. The PL spectra showed that the reduction of ADS131 BE by potassium does not affect the photoluminescence properties.

### Example 15.

This Example describes the preparation and performance of a single layer electrooptic device ITO/PEDOT/K-ADS131 BE/AI, using potassium - reduced ADS131 BE as the electro-active polymeric material, and a bare Al cathode. First, an aqueous solution of PEDOT (poly(3,4-ethylenedioxythiphene, obtained from Bayer Corporation) was spin-coated on a glass/ITO substrate (that had previously been treated with ultraviolet radiation and ozone for 10 minutes), and then baked for 60 minutes at 180 °C in air. A glass/ITO substrate having a PEDOT layer of approximately 65 nanometers thickness was thus obtained. The PEDOT - coated glass/ITO substrate was placed in a controlled atmosphere glove - box (where both moisture and oxygen are controlled to be at a concentration of less than 1 part per million). A solution of potassium-reduced ADS131 BE (prepared as described above in Example 18) was next prepared in the glove box. A film of the K - reduced ADS131 BE (sometimes referred to as K-ADS131 BE) was spin-cast from the DME solution on the PEDOT - coated glass/ITO layer. Then AI or was thermally evaporated at a base vacuum of 2 X 10⁻⁶ Torr to form the cathode layer on the K-ADS131 BE layer. Finally, the device was encapsulated using a glass slide and sealed with an optical adhesive.

### Comparative Example 1.

The electrooptic device (ITO/PEDOT/ADS131 BE/AI-NaF) was prepared using a procedure similar to that used in Example 15, except that ADS131 BE was used instead of K-ADS131 BE to coat the ITO glass substrate, and a bilayer cathode Al-NaF was used instead of a bare Al cathode.

### Comparative Example 2.

The electrooptic device (ITO/PEDOT/ADS131 BE/AI) was prepared using a procedure similar to that used in Comparative Example 1, except that a bare Al cathode was used instead of a NaF-Al bilayer cathode.

### Example 16.

This Example describes the preparation and performance of an electrooptic device ITO/PEDOT/poly(TPD)/K-ADS131 BE/AI. Poly(TPD) was used as a charge confinement layer. Poly(TPD) stands for poly[N,N'-bis(4-butylphenyl)-N,N'-bis(phenyl)-benzidine (ADS254BE, purchased from American Dye Sources, Inc., Canada, and used as received without any further purification). The procedure used was similar to that described in Example 19, except that a layer of poly(TPD) was deposited on the ITO/PEDOT layer, followed by deposition of the K-ADS131 BE layer and the AI cathode layer.

### Comparative Example 3.

The electrooptic device ITO/PEDOT/Poly(TPD)/ADS131 BE//NaF-AI was prepared using the same general procedure as described in Example 16, except that the neutral polymeric material ADS131 BE was used instead of K-ADS131 BE, and a bilayer cathode NaF/AI was used instead of a bare Al.

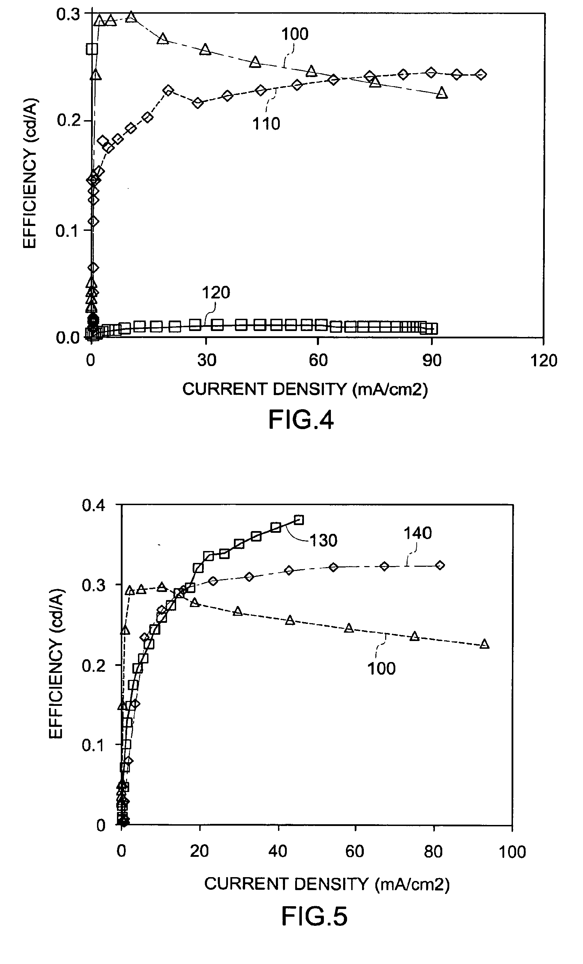

The performance of the devices prepared above is shown in Figures 4 and 5.
Figures 4 and 5 show the plot of current density in milliamperes per square centimeter (mA/cm²) as a function of Efficiency given in candela per ampere (cd/A). The plots 100 and 110 in Figure 4 for the electrooptic devices of Example 15 and Comparative Example 1, respectively, show that the device of Example 15 with K-ADS131 as the electro-active layer and a bare Al cathode had an efficiency (measured in candela per ampere, cd/A) comparable to that of the prior art device of Comparative Example 1, which has un-doped ADS131 as the electro-active layer and a NaF/Al bilayer cathode. Further, comparison of the plots 110 and 120 for the electrooptic devices of Example 15 and Comparative Example 2, respectively, shows that the device of Example 15 has a far higher efficiency (greater than 10 - fold) than the device of Comparative Example 2, which employed the neutral polymeric species ADS131 BE as the electro-active layer, and a bare AI cathode. When a poly(TPD) layer is included as a charge confinement layer between the ITO/PEDOT layer and the electro-active layer, as in Example 16, a further significant enhancement in device efficiency, relative to the device of Example 15 can be achieved, as seen from comparing plot 110 in Figure 4 and plot 130 in Figure 5. Comparing the performance of the devices of Comparative Example 3 and Example 16 shows that the efficiency of the device which has a poly(TPD) layer charge block layer, K-ADS131BE as the electro-active layer, and bare Al cathode is higher than the efficiency of the device having poly(TPD) layer charge blocking layer, ADS131 BE as the electro-active layer, and a NaF-Al bilayer cathode, at least up to a current density of about 40 milliamperes per square centimeter, as can be seen by comparing plots 130 and 140 in Figure 5. These results clearly show that one can achieve better device performance by using the reduced polymeric organic materials as the electro-active material, without the need for using corrosive materials like NaF, which can lead to reduced device lifetime at no significant increase in device efficiency.

For completeness, various aspects of the invention are set out in the following numbered clauses:
1. An electrooptic device comprising:
   a first conductive layer;
   a second conductive layer; and
   an electro-active layer disposed between the first and second conductive layers and comprising a first organic electro-active material,
   wherein the first organic electro-active material comprises a reduced organic material.
2. The electrooptic device of clause 1, wherein the reduced organic material comprises at least one cationic species and a reduced polymer species comprising at least one additional electron relative to a corresponding neutral polymeric organic precursor.
3. The electrooptic device of clause 1, wherein the reduced organic material comprises at least one cationic species and a reduced organic species comprising at least one additional electron relative to a corresponding neutral non-polymeric organic precursor.
4. The electrooptic device of clause 2, wherein said corresponding neutral polymeric organic precursor comprises at least one aromatic radical.
5. The electrooptic device of clause 4, wherein said corresponding neutral polymeric organic precursor comprises structural units (1) 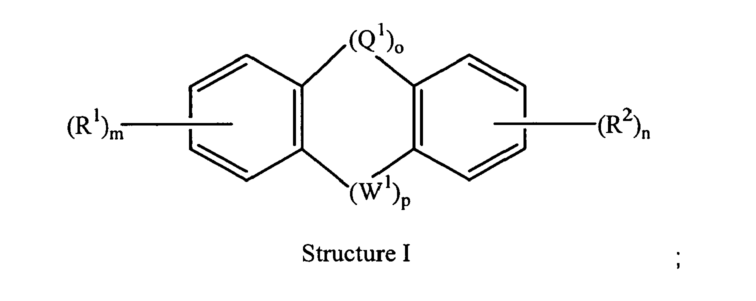 wherein R¹ and R² are independently at each occurrence a halogen atom, a C₁ - C₂₀ aliphatic radical, a C₂ - C₁₀ aromatic radical, a C₃ - C₁₀ cycloaliphatic radical, a nitro group, or a cyano group; "m" and "n" are independently integers from and including 0 to 4; "o" and "p" are independently integers from and inclduing 0 to 1,and wherein o + p is greater than 0; W¹ is a bond, the group N 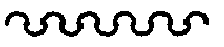 , an oxygen atom, a sulfur atom, a carbonyl group, the group C-R³, the group N-R³, or the group, 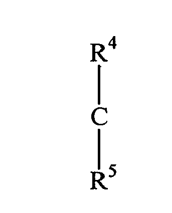 wherein R³, R⁴ and R⁵ are a hydrogen atom, a halogen atom, a polymer chain, a C₁ - C₂₀ aliphatic radical, a C₂ - C₁₀ aromatic radical, or a C₃ - C₁₀ cycloaliphatic radical; and
   Q¹ is a bond, a carbonyl group, or the group 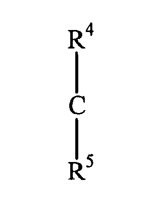 wherein R⁴ and R⁵ are independently a hydrogen atom, a halogen atom, a polymer chain, a C₁ - C₂₀ aliphatic radical, a C₂ - C₁₀ aromatic radical, or a C₃ - C₁₀ cycloaliphatic radical.
6. The electrooptic device of clause 4, wherein said corresponding neutral polymeric organic precursor comprises structural units (II) 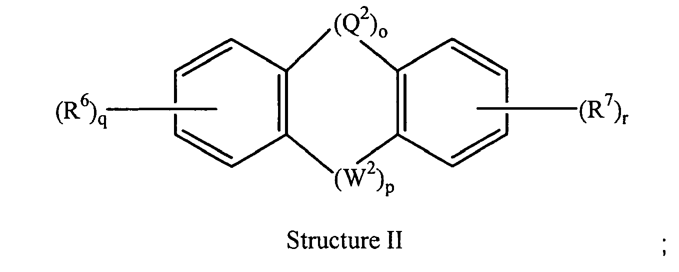 wherein R⁶ and R⁷ are independently at each occurrence a halogen atom, a C₁ - C₂₀ aliphatic radical, a C₂ - C₁₀ aromatic radical, a C₃ - C₁₀ cycloaliphatic radical, a nitro group, a cyano group, or a polymer chain; "q" and "r" are independently integers from and including 0 to 4, wherein q + r is greater than 0; "o" and "p" are independently integers from and including 0 to 1, wherein o + p is greater than 0; W² is a bond, N 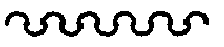 , an oxygen atom, a sulfur atom, a carbonyl group, the group C-R³, the group N-R³, or the group 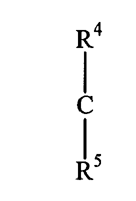 wherein R³, R⁴ and R⁵ are independently a hydrogen atom, a halogen atom, a polymer chain, a C₁ - C₂₀ aliphatic radical, a C₂ - C₁₀ aromatic radical, or a C₃ - C₁₀ cycloaliphatic radical; and
   Q² is a bond, a carbonyl group, 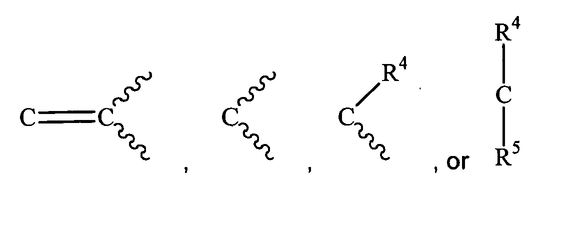 , wherein R⁴ and R⁵ are independently a hydrogen atom, a halogen atom, a polymer chain, a C₁ - C₂₀ aliphatic radical, a C₂ - C₁₀ aromatic radical, or a C₃ - C₁₀ cycloaliphatic radical.
7. The electrooptic device of clause 4, wherein said corresponding neutral polymeric organic precursor comprises structural units (III) 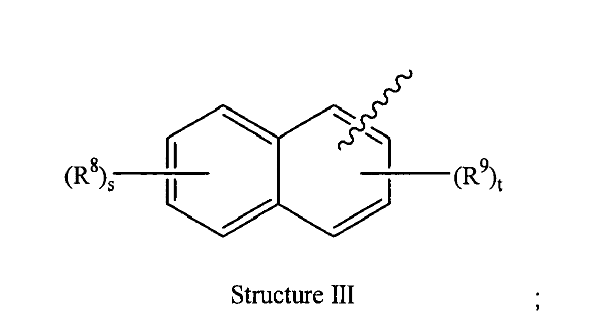 wherein R⁸ and R⁹ are independently at each occurrence a halogen atom, a C₁ - C₂₀ aliphatic radical, a C₂ - C₁₀ aromatic radical, a C₃ - C₁₀ cycloaliphatic radical, a nitro group, or a cyano group; "s" is an integer from and including 0 to 4; and "t" is an integer from and including 0 to 3.
8. The electrooptic device of clause 4, wherein said corresponding neutral polymeric organic precursor comprises structural units (IV) 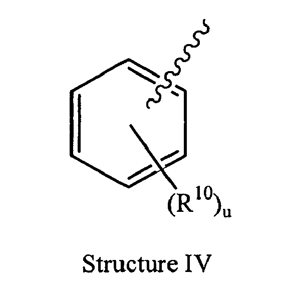 wherein R¹⁰ is independently at each occurrence a halogen atom, a C₁ - C₂₀ aliphatic radical, a C₂ - C₁₀ aromatic radical, a C₃ - C₁₀ cycloaliphatic radical, a nitro group, or a cyano group; and "u" is an integer from and including 0 to 5.
9. The electrooptic device of clause 4, wherein said corresponding neutral polymeric organicprecursor comprises structural units (V) 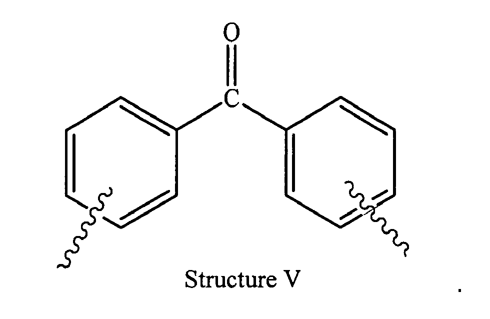
10. The electrooptic device of clause 4, wherein said corresponding neutral polymeric organic precursor comprises structural units (VI) 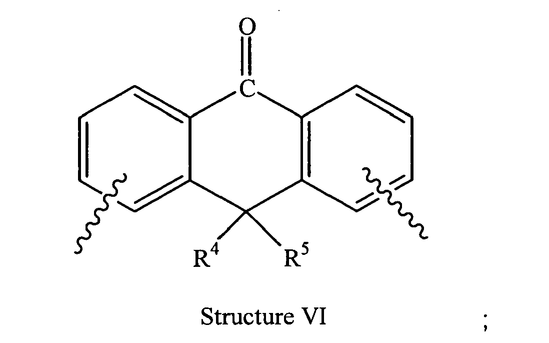 wherein R⁴ and R⁵ are independently hydrogen, a C₁ - C₂₀ aliphatic radical, a C₂ - C₁₀ aromatic radical, or a C₃ - C₁₀ cycloaliphatic radical.
11. The electrooptic device of clause 4, whereinsaid corresponding neutral polymeric organicprecursor comprises structural units (VII) 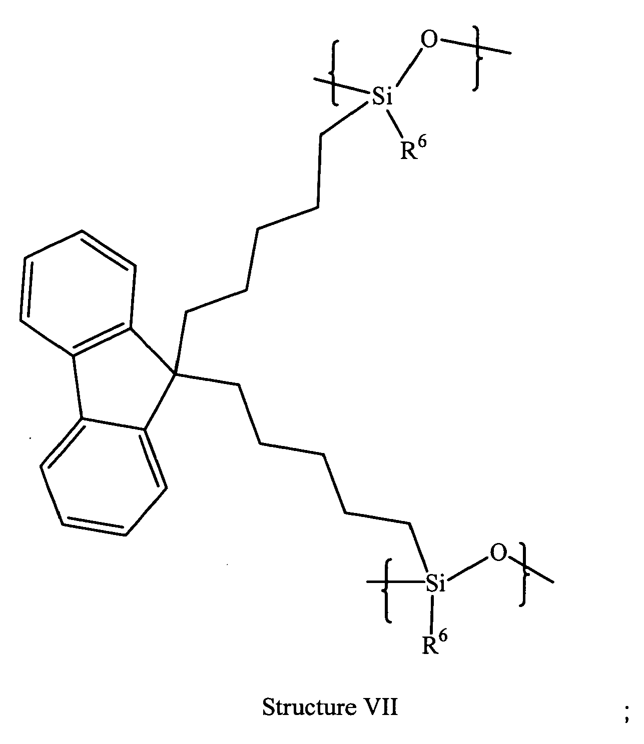 comprising siloxane repeat units, wherein R⁶ is independently at each occurrence a C₁- C₂₀ aliphatic radical, a C₂ - C₁₀ aromatic radical, or a C₃ - C₁₀ cycloaliphatic radical.
12. The electrooptic device of clause 4, whereinsaid corresponding neutral polymeric organicprecursor comprises structural units (VIII) 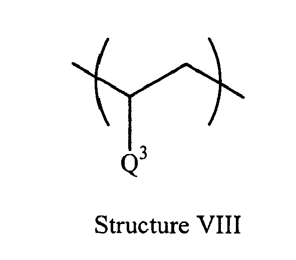 wherein Q³ is a naphthyl group or a binaphthyl group.
13. The electrooptic device of clause 4, whereinsaid corresponding neutral polymeric organic precursor comprises structural units (IX) 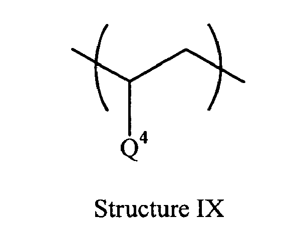 wherein Q⁴ is a phenyl group or a biphenyl group.
14. The electrooptic device of clause 4, wherein said corresponding neutral polymeric organicprecursor comprises at least one structural unit selected from the group consisting of para-phenylenevinylene, pyridine, para-phenylene, thiophene, fluorene, organosilane, oxadiazole, quinoline, quinoxaline, acetylene, and phenylene acetylene structural units.
15. The electrooptic device of clause 4, whereinsaid corresponding neutral polymeric organicprecursor comprises structural units derived from at least one polymerizable monomer selected from the group consisting of vinyl . naphthalene, styrene, vinyl anthracene, vinyl pentacene, vinyl chrysene, vinyl carbazole, vinyl thiophene, vinyl pyidine, and (1,4-diethynyl)benzene.
16. The electrooptic device of clause 4, whereinsaid corresponding neutral polymeric organic precursor comprises at least one polymer selected from the group consisting of poly[9,9-di(2-ethylhexyl)fluorenyl-2,7-diyl], poly[9,9-di(n-hexyl)fluorenyl-2,7-diyl], poly(3-hexylthiophene-2,5-diyl), poly(fluorenyleneethynylene), poly{[2-methoxy-5-(2'-ethylhexyloxy)]-1,4-phenylenevinylene}, poly[(9,9-dioctylfluorenyl-2,7-diyl)-alt-co-(N,N'-diphenyl)-{N,N'-di(4-butylphenyl)}-1,4-diaminobenzene)], poly[N,N'-bis(4-butylphenyl)-N,N'-bis(phenyl)benzidine], and poly(vinylcarbazole).
17. The electrooptic device of clause 4, whereinsaid corresponding neutral polymeric organic precursor comprises structural units derived from from at least one organosilicon hydride.
18. The electrooptic device of clause 17, whereinsaid organosilicon hydride comprises at least one structural unit selected from the group consisting of structures X, XI, and XII 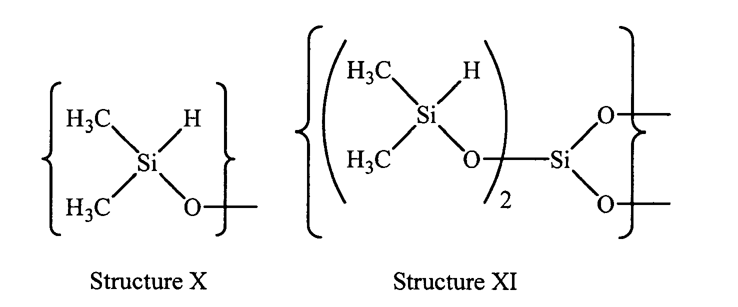 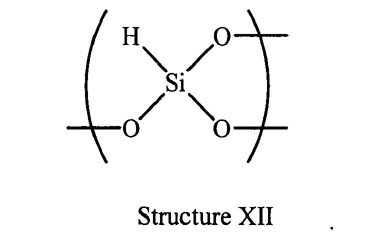
19. The electrooptic device of clause 17, whereinsaid organosilicon hydride is selected from the group consisting of CH₃)₂Si(H)O-[Si(CH₃)₂O]ₓ-Si(CH₃)₂(H), and (CH₃)₃SiO-[SiCH₃(H)O]_{x'}-[Si(CH₃)₂O]_{y'}-Si(CH₃)₃ wherein x, x' and y are independently from about 1 to about 30.
20. The electrooptic device of clause 2, wherein the reduced polymer species comprises at least one radical anion species, at least one dianion species, or a combination thereof.
21. The electrooptic device of clause 2, wherein said at least one cationic species is selected from the group consisting of cations of Lewis bases, Group 1 metal ionss, Group 2 metal ions, Group 3 metal ions, Group 4 metal ions, lanthanide ions, and rare earth metal ions.
22. The electrooptic device of clause 2, wherein the at least one cationic species is selected from the group consisting of cations of lithium, sodium, potassium, cesium, calcium, magnesium, indium, tin, zirconium, aluminum, cesium, europium, and cerium.
23. The electrooptic device of clause 1 wherein said reduced organic material is selected from the group consisting of sodium benzophenone ketyl, postassium benzophenone ketyl, and potassium-9,9-di(n-hexenyl)fluorene.
24. The electrooptic device of clause 1 wherein said reduced organic material is selected from the group consisting of potassium {poly[9,9-di(2-ethylhexyl)-fluorenyl-2,7-diyl}, and potassium poly[(9,9-dioctylfluorenyl-2,7-diyl)-alt-co-(N, N'-diphenyl)-N, N'-di(4-butylphenyl)-1,4-diaminobenzene]..
25. The electrooptic device of clause 1, wherein at least one of the first conductive layer or second conductive layer is substantially transparent.
26. The electrooptic device of clause 1, further comprising at least one layer selected from the group consisting of an electron transport layer, a hole transport layer, or a charge confinement layer.
27. The electrooptic device of clause 26, wherein the hole transport layer comprises at least one hole transport material selected from the group consisting of N,N'-diphenyl-N,N'-bis(4-methylphenyl)-[1,1'-biphenyl]-4,4'-diamine, a substituted poly(phenylene vinylene) polymer, an unsubstituted poly(phenylene vinylene) polymer, poly(methylphenylsilane), poly(vinylcarbazole), triphenylamine tetramer, poly(pyrdine-2,5-diyl), poly(1,10-phenanthroline-3-diyl), poly(4,4'-disubstituted-2,2'-bithiazole-5,5'-diyl), and poly(methyl methacrylate) having N,N'-diphenyl-N,N'-bis(4-methylphenyl)-[1,1'-biphenyl]-4,4'-diamine pendant groups.
28. The electrooptic device of clause 26, wherein the electron transport layer comprises at least one electron transport material selected from the group consisting of 2-(4-biphenylyl)-5-(4-tert-butylphenyl)-1,3,4-oxadiazole, tris(8-hydroxyquinoline)aluminum, 3-(4-biphenylyl)-4-phenyl-5-(4-tertbutylphenyl)-1,2,4-triazole, 2,5-diphenyl-1,3-oxadiazole, distyrylbenzene, 2,5-bis[2-(4-tertbutylphenyl)-1,3,4-oxadiazol-5-yl]pyridine, 2,3-diphenylquinoxaline, triazine, triazole, bithiazole, poly(methyl methacrylate) having pendant groups comprising distyrylbenzyl groups, poly(methyl methacrylate) having pendant groups comprising 2-(4-biphenylyl)-5-(benzyl)-1,3,4-oxadiazole groups, and poly(methyl methacrylate) having pendant groups comprising 2,5-diphenyl-1,3,4-oxadiazole groups.
29. The electrooptic device of clause 1, comprising a second organic electro-active material.
30. The electrooptic device of clause 1, wherein the electro-active layer comprises at least one dye seleced from the group consisting of fluorescent dyes, and phosphorescent dyes.
31. A product, comprising an electrooptic device, said electrooptic device comprising:
   a first conductive layer;
   a second conductive layer; and
   an electro-active layer disposed between the first and second conductive layers and comprising a first organic electro-active material,
   wherein the first organic electro-active material comprises a reduced organic material.
32. The product of clause 31, wherein the product is selected from the group consisting of an organic photovoltaic device, a photodetector, a display device, and an organic light emitting device.
33. A method for fabricating an electrooptic device, said method comprising:
   disposing a layer of an electro-active material between a first conductive layer and a second conductive layer to form the electrooptic device,
   wherein the electro-active material comprises a first organic electro-active material, the first organic electro-active material comprising a reduced organic material.
34. The method of clause 33, further comprising disposing a layer of a hole transport material between the layer of the electro-active material and the first conductive layer or the second second conductive layer.
35. The method of clause 33, further comprising disposing a layer of an electron transport material between the layer of the electro-active material and the first conductive layer or the second conductive layer.
36. An electro-active organic material comprising a least one cationic species and a reduced organic material, said reduced organic material comprising at least one additional electron relative to a corresponding reducible neutral precursor.
37. The electro-active organic material selected of clause 36, wherein said cationic species is selected from the group consisting of potassium and sodium, and said reduced organic material is selected from the group consisting {poly[9,9-di(2-ethylhexyl)-fluorenyl-2,7-diyl} radical anion, {poly[9,9-di(2-ethylhexyl)-fluorenyl-2,7-diyl} dianion, {poly[9,9-di(2-ethylhexyl)-fluorenyl-2,7-diyl} radical polyanion, poly[(9,9-dioctylfluorenyl-2,7-diyl)-alt-co-(N,N'-diphenyl)-N,N'-di(4-butylphenyl)-1,4-diaminobenzene] radical anion, poly[(9,9-dioctylfluorenyl-2,7-diyl)-alt-co-(N,N'-diphenyl)-N,N'-di(4-butylphenyl)-1,4-diaminobenzene] dianion, and poly[(9,9-dioctylfluorenyl-2,7-diyl)-alt-co-(N,N'-diphenyl)-N,N'-di(4-butylphenyl)-1,4-diaminobenzene] radical polyanion.
38. A display device comprising a a plurality of electrooptic devices, at least one of said electrooptic devices comprising a first electro-active organic material, said first organic electro-active material comprising a reduced organic material.
39. An electrooptic device consisting essentially of:
   a first conductive layer;
   a second conductive layer; and
   an electro-active layer disposed between the first and second conductive layers and comprising a first organic electro-active material,
   wherein the first organic electro-active material comprises a reduced organic material.
40. A surface modified electrode comprising:
   at least one conductive layer; and
   at least one reduced polymeric material disposed upon a surface of said conductive layer, the reduced polymeric material comprising at least one additional electron relative to a corresponding neutral polymeric precursor and at least one cationic species.
41. A coating composition comprising:
   at least one reduced polymeric organic material, the reduced polymeric organic material comprising at least one additional electron relative to a corresponding neutral polymeric organic precursor, the reduced polymeric organic material comprising at least one cationic species; and
   at least one polar aprotic solvent.
42. An electrooptic device comprising:
   a surface modified first electrode;
   a second electrode; and
   an electroluminescent organic material disposed between the first electrode and the second electrode;
   wherein the surface modified first electrode comprises at least one conductive layer, and at least one reduced polymeric material disposed upon a surface of said conductive layer, the reduced polymeric material comprising at least one additional electron relative to a corresponding neutral polymeric precursor and at least one cationic species.
43. The electrooptic device of clause 43, wherein at least one of the first or second electrode is transparent.
44. A surface modified electrode comprising:
   at least one conductive layer; and
   at least one reduced organic material disposed upon a surface of said conductive layer, the reduced organic material comprising at least one additional electron relative to a corresponding neutral precursor and at least one cationic species.
45. The surface modified electrode of clause 44 wherein the reduced organic material is selected from the group consisting of sodium benzophenone ketyl, postassium benzophenone ketyl, and potassium-9,9-di(n-hexenyl)fluorene.
46. An electrooptic device comprising:
   a cathode;
   an anode; and
   an electro-active layer disposed between the cathode;
   wherein the electro-active layer comprises a reduced polyfluorene.
47. An electrooptic device comprising:
   a first conductive layer;
   a second conductive layer; and
   an electro-active layer disposed between the first and second conductive layers and comprising a first organic electro-active material, said first organic electro-active material having been prepared by a method comprising a step of contacting a neutral organic precursor with a reducing agent capable of transferring at least one electron to the neutral organic precursor.
48. An electrooptic device according to clause 47 wherein said reducing agent comprises a metal selected from the group consisting of alkali metals and alkaline earth metals.
49. An electrooptic device according to clause 47 wherein said contacting is carried out in a solvent selected from the group consisting of aliphatic ether solvents, cycloaliphatic ether solvents, and aromatic solvents.
50. An electrooptic device according to clause 47 wherein said first organic electro-active material is selected from the group consisting of polymeric organic electro-active materials.

## Claims

1. An electrooptic device comprising:
a first conductive layer;
a second conductive layer; and
an electro-active layer disposed between the first and second conductive layers and comprising a first organic electro-active material,
wherein the first organic electro-active material comprises a reduced organic material.

2. A method for fabricating an electrooptic device, said method comprising:
disposing a layer of an electro-active material between a first conductive layer and a second conductive layer to form the electrooptic device,
wherein the electro-active material comprises a first organic electro-active material, the first organic electro-active material comprising a reduced organic material.

3. An electro-active organic material comprising a least one cationic species and a reduced organic material, said reduced organic material comprising at least one additional electron relative to a corresponding reducible neutral precursor.

4. A display device comprising a a plurality of electrooptic devices, at least one of said electrooptic devices comprising a first electro-active organic material, said first organic electro-active material comprising a reduced organic material.

5. A surface modified electrode comprising:
at least one conductive layer; and
at least one reduced polymeric material disposed upon a surface of said conductive layer, the reduced polymeric material comprising at least one additional electron relative to a corresponding neutral polymeric precursor and at least one cationic species.

6. A coating composition comprising:
at least one reduced polymeric organic material, the reduced polymeric organic material comprising at least one additional electron relative to a corresponding neutral polymeric organic precursor, the reduced polymeric organic material comprising at least one cationic species; and
at least one polar aprotic solvent.

7. An electrooptic device comprising:
a surface modified first electrode;
a second electrode; and
an electroluminescent organic material disposed between the first electrode and the second electrode;
wherein the surface modified first electrode comprises at least one conductive layer, and at least one reduced polymeric material disposed upon a surface of said conductive layer, the reduced polymeric material comprising at least one additional electron relative to a corresponding neutral polymeric precursor and at least one cationic species.

8. A surface modified electrode comprising:
at least one conductive layer; and
at least one reduced organic material, said reduced organic material comprising at least one additional electron relative to a corresponding neutral polymeric precursor and at least one cationic species.

9. An electrooptic device comprising:
a cathode;
an anode; and
an electro-active layer disposed between the cathode;
wherein the electro-active layer comprises a reduced polyfluorene.

10. An electrooptic device comprising:
a first conductive layer;
a second conductive layer; and
an electro-active layer disposed between the first and second conductive layers and comprising a first organic electro-active material, said first organic electro-active material having been prepared by a method comprising a step of contacting a neutral organic precursor with a reducing agent capable of transferring at least one electron to the neutral organic precursor.
